# EUROPEAN PATENT APPLICATION

(11) **EP 4 485 521 A1**
(43) Date of publication of application: **01.01.2025**
(21) Application number: 24166323.6
(22) Date of filing: 26.03.2024
(51) Int. Cl.: H01L 21/8234, H01L 21/768, H01L 23/528, H01L 27/088, H01L 29/775, H01L 29/786, H01L 29/417

(54) **SEMICONDUCTOR DEVICE WITH BACKSIDE CONTACT AND BURIED SPACER**

(30) Priority: 30.06.2023 KR 20230085184
(71) Applicant: Samsung Electronics Co., Ltd., Suwon-si, Gyeonggi-do 16677 (KR)
(72) Inventor: YOO, Jongryeol, 16677 Suwon-si (KR)
(74) Representative: Marks & Clerk LLP

(57) **Abstract**

A semiconductor device includes an insulating substrate (105), a silicon layer (100)on the insulating substrate, a dopant layer (DEP) on the silicon layer, a buried spacer (BSP1, BSP2) on a side surface of the dopant layer, a channel pattern (CH1, CH2) on the dopant layer, the channel pattern comprising a plurality of semiconductor patterns (SP1..SP4) vertically stacked and spaced apart from each other, a source/drain pattern (SD1, SD2) on the buried spacer, the source/drain pattern connected to the channel pattern, a gate electrode (GE) on the channel pattern, the gate electrode comprising a plurality of inner electrodes between the semiconductor patterns, respectively, a lower power interconnection line (VPR1, VPR2) in a lower portion of the insulating substrate, and a backside contact (BDC1, BDC2) extending into the insulating substrate and the silicon layer to electrically connect the lower power interconnection line to the source/drain pattern. A side surface of the backside contact is in contact with the silicon layer and the buried spacer.

## Description

### BACKGROUND

The present disclosure relates generally to a semiconductor device, and more particularly, to a semiconductor device including a field-effect transistor.

Semiconductor devices may include integrated circuits including metal-oxide-semiconductor field-effect transistors (MOSFETs). As sizes and design rules of semiconductor devices have been reduced, MOSFETs have been scaled down. Operating characteristics of semiconductor devices may be deteriorated by reduction in size of MOSFETs. Accordingly, various methods for forming semiconductor devices having excellent performance while overcoming limitations caused by high integration have been studied.

### SUMMARY

Embodiments of the inventive concepts may provide a semiconductor device with improved electrical characteristics.

In an aspect, a semiconductor device may include an insulating substrate, a silicon layer on the insulating substrate, a dopant layer on the silicon layer, a buried spacer on a side surface of the dopant layer, a channel pattern on the dopant layer, the channel pattern comprising a plurality of semiconductor patterns stacked and spaced apart from each other, a source/drain pattern on the buried spacer, the source/drain pattern connected to the channel pattern, a gate electrode on the channel pattern, the gate electrode comprising a plurality of inner electrodes disposed between the plurality of semiconductor patterns, respectively, a lower power interconnection line in a lower portion of the insulating substrate, and a backside contact penetrating (i.e., extending into) the insulating substrate and the silicon layer to electrically connect the lower power interconnection line to the source/drain pattern. A side surface of the backside contact may be in contact with the silicon layer and the buried spacer.

In an aspect, a semiconductor device may include an insulating substrate including a horizontal portion and a protruding portion, a silicon layer on the insulating substrate, a dopant layer on the silicon layer, a first buried spacer and a second buried spacer provided on both side surfaces of the dopant layer, respectively, a channel pattern on the dopant layer, a first source/drain pattern and a second source/drain pattern connected to both sides of the channel pattern, respectively, a gate electrode on the channel pattern, a lower power interconnection line in a lower portion of the insulating substrate, and a backside contact penetrating the insulating substrate and the silicon layer to electrically connect the lower power interconnection line to the first source/drain pattern. The protruding portion may be in contact with a lower portion of the second source/drain pattern. The silicon layer may be disposed between the protruding portion and the backside contact. A first side surface of the first buried spacer may be in contact with the backside contact, and a second side surface of the second buried spacer may be in contact with the protruding portion. The first and second buried spacers may include an insulating material having a dielectric constant lower than that of silicon oxide.

In an aspect, a semiconductor device may include an insulating substrate, a silicon layer on the insulating substrate, a dopant layer on the silicon layer, a buried spacer on a side surface of the dopant layer, a channel pattern on the dopant layer, the channel pattern comprising a plurality of semiconductor patterns stacked and spaced apart from each other, a source/drain pattern on the buried spacer, the source/drain pattern connected to the channel pattern, a gate electrode on the channel pattern, a lower power interconnection line in a lower portion of the insulating substrate, and a backside contact penetrating the insulating substrate and the silicon layer to electrically connect the lower power interconnection line to the source/drain pattern. Each of the dopant layer and the silicon layer may include at least one dopant of fluorine (F), argon (Ar), oxygen (O), or nitrogen (N). A first concentration of the dopant in the dopant layer may be greater than a second concentration of the dopant in the silicon layer.

At least some of the above and other features of the disclosure are set out in the claims.

### BRIEF DESCRIPTION OF THE DRAWINGS

FIGS. 1 to 3 are conceptual views illustrating logic cells of an example semiconductor device, according to some embodiments of the inventive concepts.
FIG. 4 is a plan view illustrating a semiconductor device according to some embodiments of the inventive concepts.
FIGS. 5A, 5B, 5C, 5D and 5E are cross-sectional views taken along lines A-A', B-B', C-C', D-D' and E-E' of FIG. 4, respectively.
FIG. 5F is a graph illustrating a dopant concentration of a silicon layer according to a third center line of FIG. 5B.
FIGS. 6A to 16D are cross-sectional views illustrating intermediate processes in an example method of manufacturing a semiconductor device, according to some embodiments of the inventive concepts.
FIGS. 17 to 20 are enlarged cross-sectional views illustrating intermediate processes in an example method of forming a region 'N' of FIG. 11A, according to some embodiments of the inventive concepts.

### DETAILED DESCRIPTION

Illustrative embodiments of the inventive concept will be described herein with reference to the accompany drawings, wherein like reference numerals (when used) indicate corresponding elements throughout the several views.

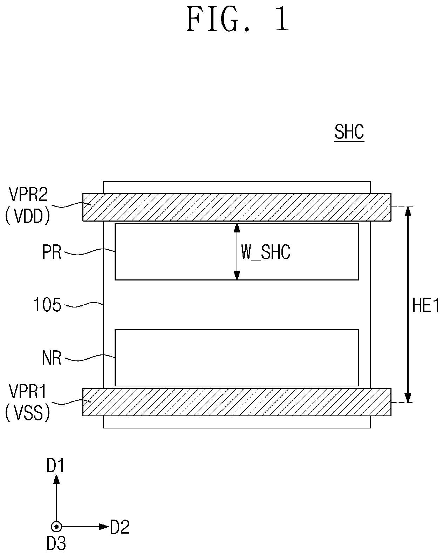

FIGS. 1 to 3 are conceptual plan views illustrating logic cells of an example semiconductor device according to some embodiments of the inventive concepts.

Referring to FIG. 1, a single height cell SHC may be provided. More particularly, a first lower power interconnection line VPR1 and a second lower power interconnection line VPR2 may be provided in a lower portion of a substrate 105. The first lower power interconnection line VPR1 may be a path (i.e., connection) through which a source voltage VSS (e.g., a ground voltage) is provided. The second lower power interconnection line VPR2 may be a path through which a drain voltage VDD (e.g., a power voltage) is provided.

The single height cell SHC may be defined between the first lower power interconnection line VPR1 and the second lower power interconnection line VPR2. The single height cell SHC may include a p-channel metal-oxide-semiconductor field-effect transistor (PMOSFET) region PR and an n-channel metal-oxide-semiconductor field-effect transistor (NMOSFET) region NR. In other words, the single height cell SHC may have a CMOS structure provided between the first lower power interconnection line VPR1 and the second lower power interconnection line VPR2.

Each of the PMOSFET region PR and the NMOSFET region NR may have a single width W_SHC in a first direction D1 parallel to an upper surface of the substrate 105 (i.e., a first horizontal direction). A length of the single height cell SHC in the first direction D1 may be defined as a first height HE1. The first height HE1 may be substantially equal to a distance (e.g., a pitch) between the first lower power interconnection line VPR1 and the second lower power interconnection line VPR2.

The single height cell SHC may form a logic cell. In the present specification, the logic cell may be defined as a logic element (e.g., an AND element, an OR element, an XOR element, an XNOR element, an inverter, etc.) for performing a specific function. In other words, the logic cell may include transistors and interconnection lines connecting the transistors to each other, which constitute the logic element.

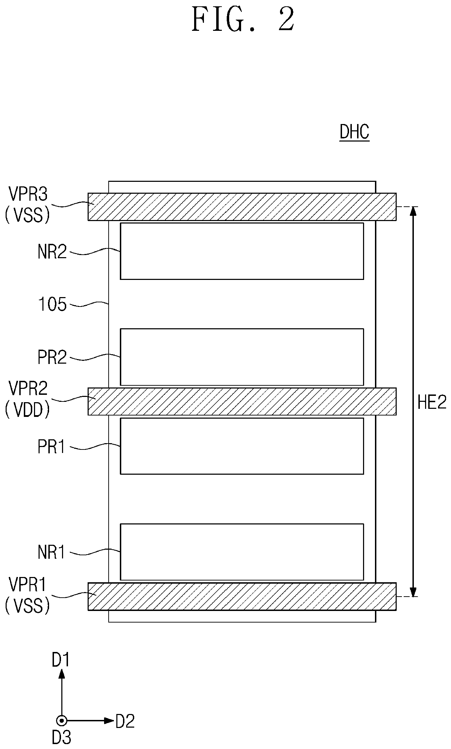

Referring to FIG. 2, a double height cell DHC may be provided. More particularly, a first lower power interconnection line VPR1, a second lower power interconnection line VPR2 and a third lower power interconnection line VPR3 may be provided on a substrate 105. The second lower power interconnection line VPR2 may be disposed between the first lower power interconnection line VPR1 and the third lower power interconnection line VPR3 in the first direction D1. The third lower power interconnection line VPR3 may be a path through which the source voltage VSS is provided.

The double height cell DHC may be defined between the first lower power interconnection line VPR1 and the third lower power interconnection line VPR3 in the first direction D1. The double height cell DHC may include a first PMOSFET region PR1, a second PMOSFET region PR2, a first NMOSFET region NR1, and a second NMOSFET region NR2.

The first NMOSFET region NR1 may be adjacent to the first lower power interconnection line VPR1. The second NMOSFET region NR2 may be adjacent to the third lower power interconnection line VPR3. The first and second PMOSFET regions PR1 and PR2 may be adjacent to the second lower power interconnection line VPR2 (i.e., on opposite sides of the second lower power interconnection line VPR2) in the first direction D1. The second lower power interconnection line VPR2 may be disposed between the first and second PMOSFET regions PR1 and PR2 when viewed in a plan view.

A length of the double height cell DHC in the first direction D1 may be defined as a second height HE2. The second height HE2 may be about twice the first height HE1 of FIG. 1. The first and second PMOSFET regions PR1 and PR2 of the double height cell DHC may be combined with each other to operate as a single PMOSFET region. Thus, a size of a channel of a PMOS transistor of the double height cell DHC may be greater than a size of a channel of a PMOS transistor of the single height cell SHC described above in conjunction with FIG. 1.

For example, the size of the channel of the PMOS transistor of the double height cell DHC may be about twice the size of the channel of the PMOS transistor of the single height cell SHC. As a result, the double height cell DHC may operate at a higher speed than the single height cell SHC. In the inventive concepts, the double height cell DHC shown in FIG. 2 may be defined as a multi-height cell. Even though not shown in the drawings, the multi-height cell may include, for example, a triple height cell of which a cell height is about three times that of the single height cell SHC.

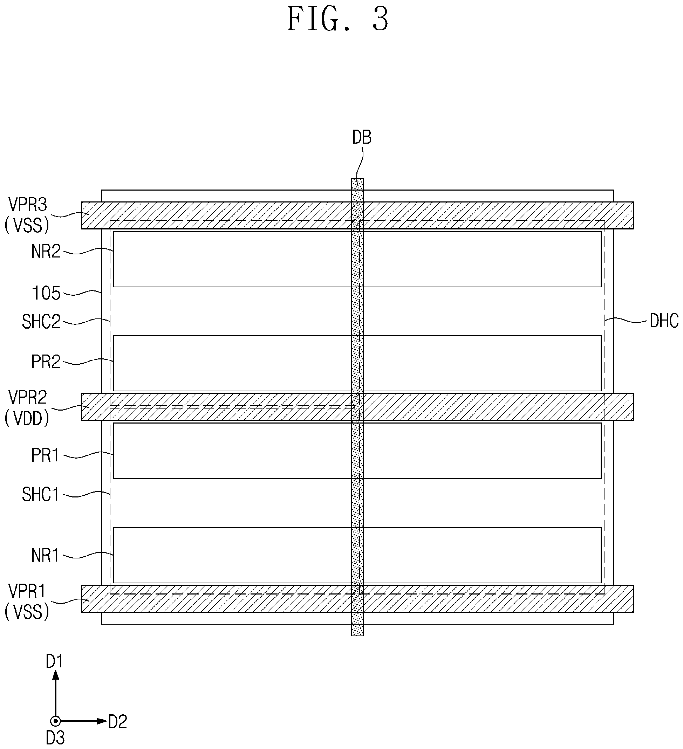

Referring to FIG. 3, a first single height cell SHC1, a second single height cell SHC2 and a double height cell DHC may be two-dimensionally arranged on a substrate 105. The first single height cell SHC1 may be disposed between first and second lower power interconnection lines VPR1 and VPR2 in the first direction D1. The second single height cell SHC2 may be disposed between second and third lower power interconnection lines VPR2 and VPR3 in the first direction D1. The second single height cell SHC2 may be adjacent to the first single height cell SHC1 in the first direction D1.

The double height cell DHC may be disposed between the first and third lower power interconnection lines VPR1 and VPR3 in the first direction D1. The double height cell DHC may be adjacent to the first and second single height cells SHC1 and SHC2 in a second direction D2, the second direction D2 intersecting the first direction D1 and parallel to the upper surface of the substrate 105 (i.e., D2 being a second horizontal direction).

An isolation structure DB may be provided between the first single height cell SHC1 and the double height cell DHC and between the second single height cell SHC2 and the double height cell DHC, the isolation structure DB extending in the first direction D1 and separating the first and second single height cells from the double height cell in the second direction D2. An active region of the double height cell DHC may be electrically isolated from an active region of each of the first and second single height cells SHC1 and SHC2 by the isolation structure DB.

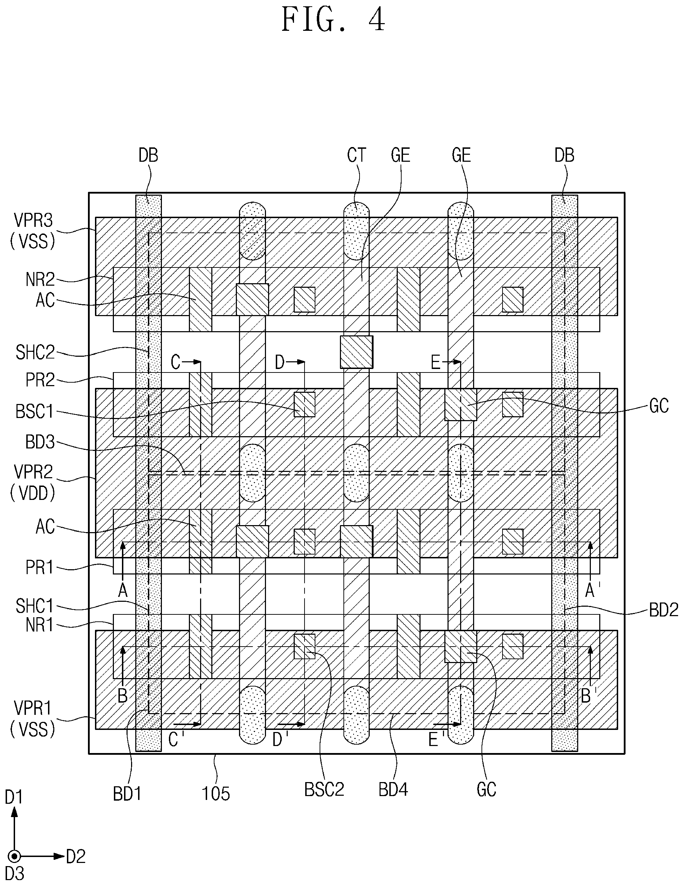

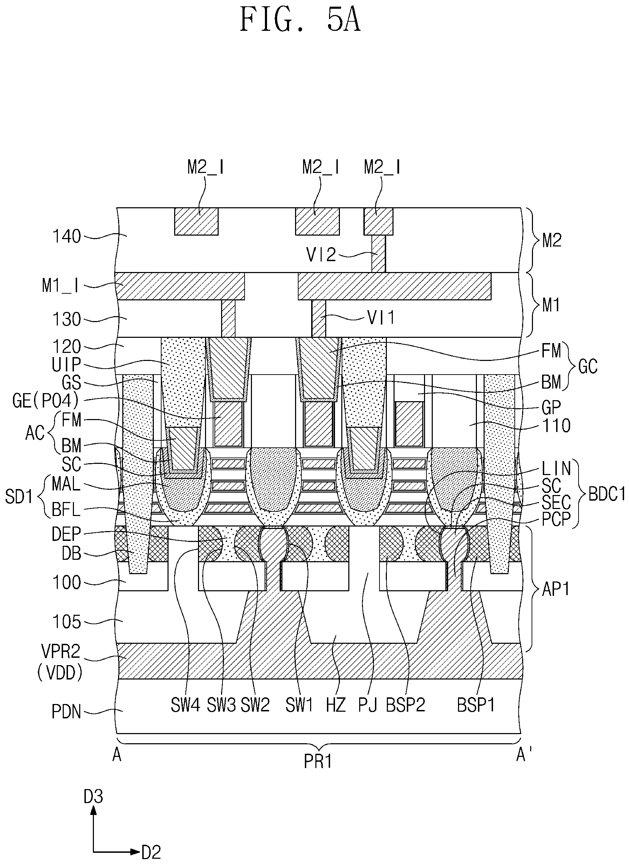

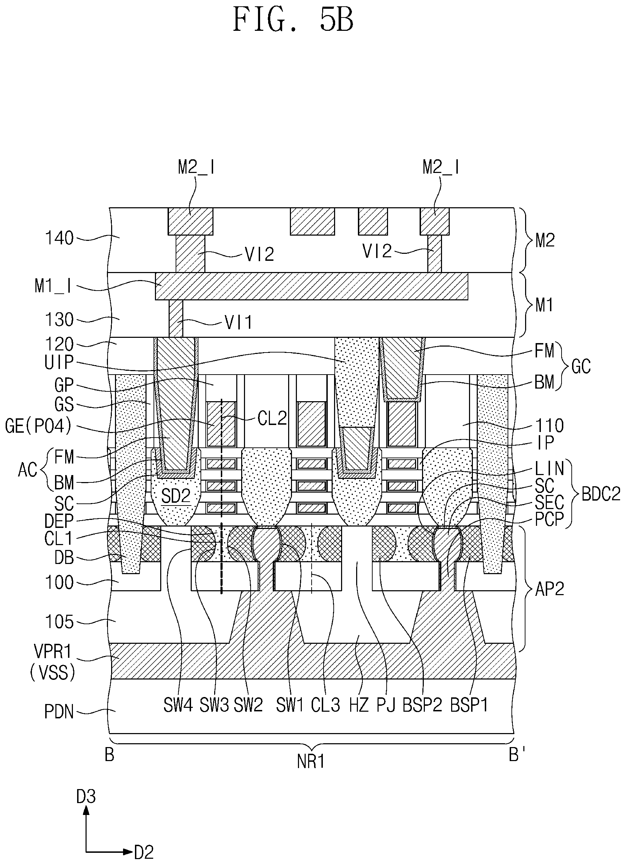

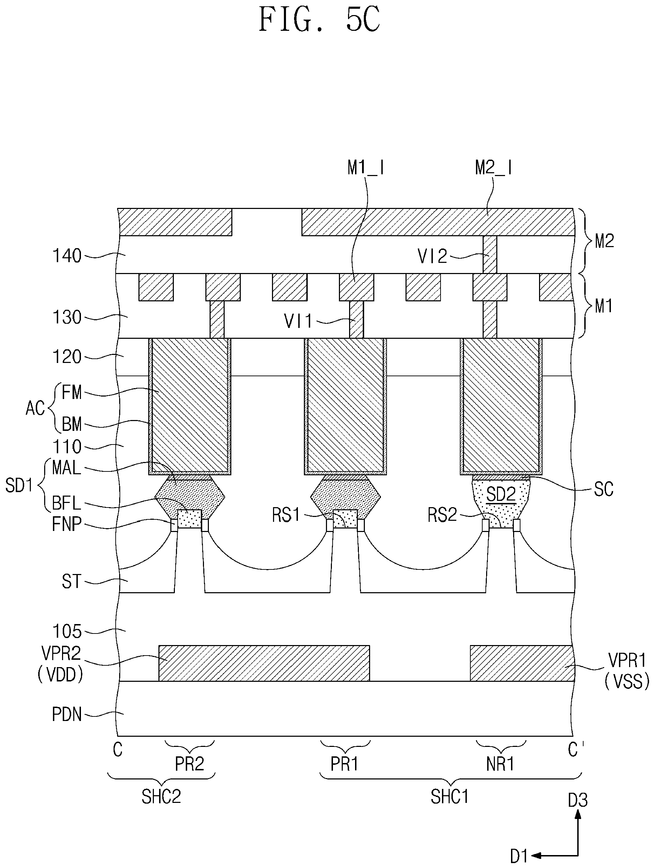

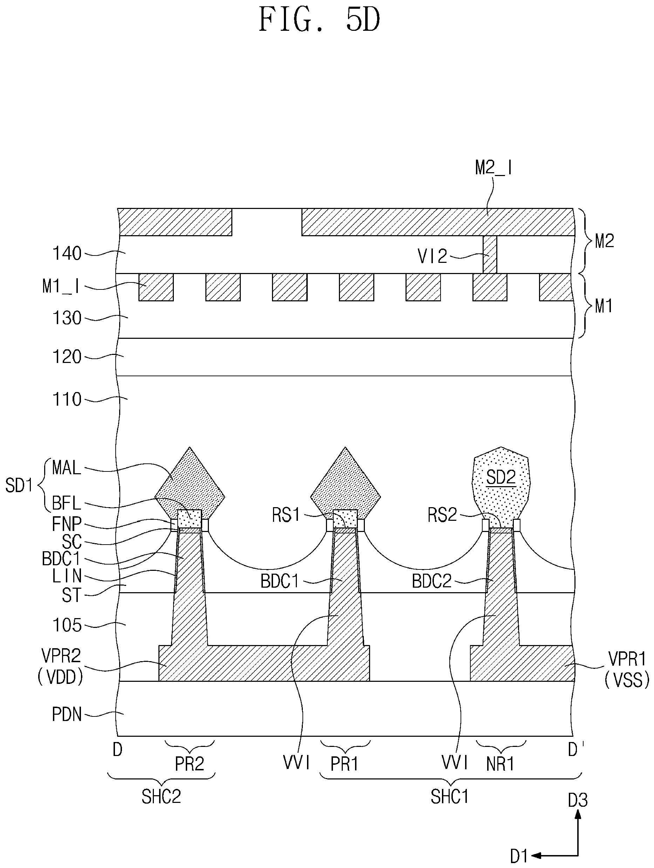

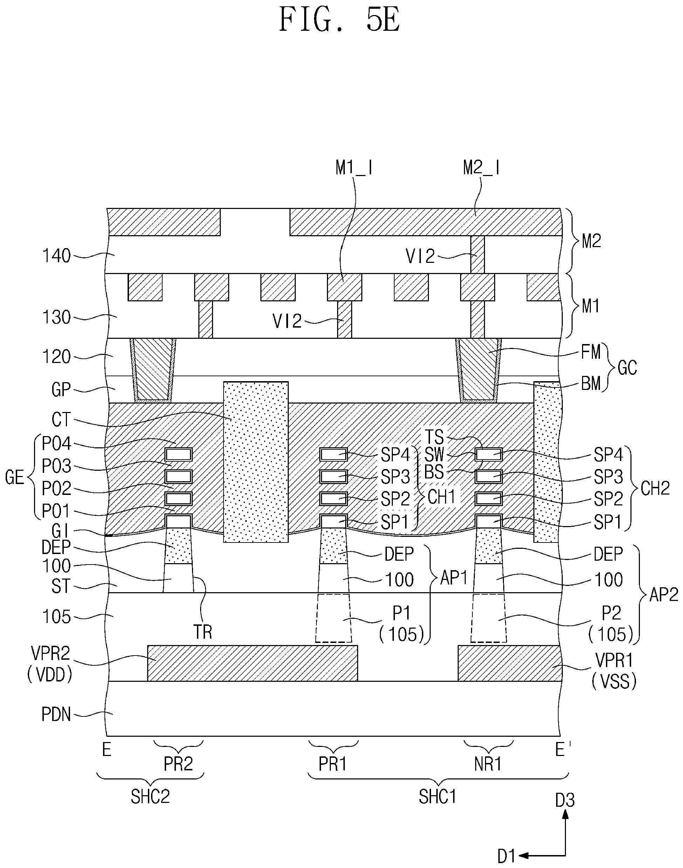

FIG. 4 is a plan view illustrating a semiconductor device according to some embodiments of the inventive concepts. FIGS. 5A, 5B, 5C, 5D and 5E are cross-sectional views taken along lines A-A', B-B', C-C', D-D' and E-E' of FIG. 4, respectively. The semiconductor device of FIGS. 4 and 5A to 5E is a more detailed example of the first and second single height cells SHC1 and SHC2 of FIG. 3.

Referring to FIGS. 4 and 5A to 5E, the first and second single height cells SHC1 and SHC2, respectively, may be provided on the substrate 105. Logic transistors constituting a logic circuit may be disposed on each of the first and second single height cells SHC1 and SHC2. The substrate 105 may include a silicon-based insulating layer. In other words, the substrate 105 may be an insulating substrate. For example, the substrate 105 may include a silicon oxide layer, a silicon nitride layer, or a silicon oxynitride layer, although embodiments are not limited thereto.

The substrate 105 may include a horizontal portion HZ, extending in the first direction D1 and/or the second direction D2, and a protruding portion PJ. Lower power interconnection lines VPR1 to VPR3 to be described later may be disposed in the horizontal portion HZ of the substrate 105. The protruding portion PJ may have a shape extending from the horizontal portion HZ in a third direction D3 perpendicular to the upper surface of the substrate 105. The protruding portion PJ may be in contact with lower portions of a first source/drain pattern SD1 and a second source/drain pattern SD2, which will be described later.

The substrate 105 may have a first PMOSFET region PR1, a second PMOSFET region PR2, a first NMOSFET region NR1, and a second NMOSFET region NR2. Each of the first PMOSFET region PR1, the second PMOSFET region PR2, the first NMOSFET region NR1 and the second NMOSFET region NR2 may extend in the second direction D2 and are separated from one another in the first direction D1. The first single height cell SHC1 may include the first NMOSFET region NR1 and the first PMOSFET region PR1, and the second single height cell SHC2 may include the second PMOSFET region PR2 and the second NMOSFET region NR2.

A first insulating pattern AP1 and a second insulating pattern AP2 may be defined by a trench TR formed in an upper portion of the substrate 105. The first insulating pattern AP1 may be provided on each of the first and second PMOSFET regions PR1 and PR2. The second insulating pattern AP2 may be provided on each of the first and second NMOSFET regions NR1 and NR2. The first and second insulating patterns AP1 and AP2 may extend in the second direction D2. The first and second insulating patterns AP1 and AP2 may be portions of the substrate 105 which vertically protrude in the third direction D3.

A device isolation layer ST may fill the trench TR. The term "fill" (or "filling," "filled," or like terms), as may be used herein, is intended to refer broadly to either completely filling a defined space (e.g., trench TR) or partially filling the defined space; that is, the defined space need not be entirely filled but may, for example, be partially filled or have voids or other spaces throughout. The device isolation layer ST may cover side surfaces of each of the first and second insulating patterns AP1 and AP2. The device isolation layer ST may include a silicon oxide layer. The device isolation layer ST may not cover first and second channel patterns CH1 and CH2 to be described later. The term "cover" (or "covering, or other like terms), as may be used herein, is intended to broadly refer to a material, layer or structure being on or over another material, layer or structure, but does not require the material, layer or structure to *entirely* cover the other material, layer or structure, unless explicitly stated to the contrary. Thus, for example, a material or layer having openings or holes therein may still be considered to cover another material or layer.

A silicon layer 100 may be provided on the substrate 105. The silicon layer 100 may be provided between the protruding portions PJ of the substrate 105. More particularly, the silicon layer 100 may be disposed between the protruding portion PJ and a backside contact BDC to be described later. The silicon layer 100 may be a semiconductor layer including silicon, germanium or silicon-germanium, although embodiments are not limited thereto. The silicon layer 100 may be a semiconductor layer including a compound semiconductor layer.

A dopant layer DEP, a first buried spacer BSP1 and a second buried spacer BSP2 may be provided on the silicon layer 100. The dopant layer DEP may be a silicon layer including a dopant. A width of the dopant layer DEP in the second direction D2 may gradually decrease and then increase as a vertical distance in the third direction D3 increases.

The first buried spacer BSP1 and the second buried spacer BSP2 may be provided on opposing side surfaces of the dopant layer DEP. In other words, the dopant layer DEP may be disposed between the first and second buried spacers BSP1 and BSP2 in the second direction D2.

The first buried spacer BSP1 may have a first side surface SW1 and a second side surface SW2 opposite to the first side surface SW1 in the second direction D2. The first side surface SW1 may be in contact with a backside contact BDC to be described later, and the second side surface SW2 may be in contact with the dopant layer DEP. The first and second side surfaces SW1 and SW2 may be curved surfaces. The first and second side surfaces SW1 and SW2 may be convex toward the dopant layer DEP. A curvature of the first side surface SW1 may be less than a curvature of the second side surface SW2.

The second buried spacer BSP2 may have a third side surface SW3 and a fourth side surface SW4 opposite to the third side surface SW3 in the second direction D2. The third side surface SW3 may be in contact with the dopant layer DEP, and the fourth side surface SW4 may be in contact with the protruding portion PJ of the substrate 105. The third side surface SW3 may be a curved surface, and the fourth side surface SW4 may be a flat surface. The curvature of the first side surface SW1 may be less than a curvature of the third side surface SW3.

The second side surface SW2 and the third side surface SW3 may correspond to opposing side surfaces of the dopant layer DEP in the second direction D2. In other words, the first and second buried spacers BSP1 and BSP2 may be spaced apart from each other by the dopant layer DEP, and thus the second side surface SW2 and the third side surface SW3 may be opposite to each other. The curvature of the second side surface SW2 may be equal to the curvature of the third side surface SW3.

It may be understood that when the curvatures of the second and third side surfaces SW2 and SW3 are equal to each other, curvature radiuses of the second and third side surfaces SW2 and SW3 may be equal to or similar to each other. For example, the similarity of the curvature radiuses of the second and third side surfaces SW2 and SW3 may mean that a ratio of the curvature radius of the third side surface SW3 to the curvature radius of the second side surface SW2 ranges from 0.9 to 1.1. In other words, when the curvature radius ratio ranges from 0.9 to 1.1 or is 1.0, the curvatures of the second side surface SW2 and the third side surface SW3 may be substantially equal to each other.

The first and second buried spacers BSP1 and BSP2 may include an insulating material having a dielectric constant lower than that of silicon oxide. For example, the insulating material may include silicon oxide (SiOₓ), silicon oxycarbonitride (SiOCN), silicon carbon nitride (SiCN), silicon oxyfluoride (SiOF), or any combination thereof, although embodiments are not limited thereto. As another example, the insulating material may include SiN_{y}, SiON, or any combination thereof.

Referring to FIG. 5E, the first insulating pattern AP1 may include a first part P1 on the first PMOSFET region PR1, the silicon layer 100 on the first part P1, and the dopant layer DEP on the silicon layer 100. The second insulating pattern AP2 may include a second part P2 on the first NMOSFET region NR1, the silicon layer 100 on the second part P2, and the dopant layer DEP on the silicon layer 100. For example, each of the first and second parts P1 and P2 may include a silicon oxide layer, a silicon nitride layer, or a silicon oxynitride layer.

The silicon layer 100 and the dopant layer DEP may include at least one dopant. For example, the dopant included in the silicon layer 100 and the dopant layer DEP may be fluorine (F), argon (Ar), oxygen (O), and/or nitrogen (N). A concentration of the dopant of the dopant layer DEP may be greater than a concentration of the dopant of the silicon layer 100. For example, the concentration of the dopant in the dopant layer DEP may range from about 0.5 atomic percent (at%) to 2 at%. The concentration of the dopant in the silicon layer 100 may range from about 0.1 at% to 0.5 at%.

Referring again to FIGS. 4 and 5A to 5E, a first channel pattern CH1 may be provided on the first insulating pattern AP1. A second channel pattern CH2 may be provided on the second insulating pattern AP2. Each of the first channel pattern CH1 and the second channel pattern CH2 may include a first semiconductor pattern SP1, a second semiconductor pattern SP2, a third semiconductor pattern SP3 and a fourth semiconductor pattern SP4, which are sequentially stacked in the third direction D3. The first to fourth semiconductor patterns SP1, SP2, SP3 and SP4 may be spaced apart from each other in a vertical direction (i.e., the third direction D3).

Each of the first to fourth semiconductor patterns SP1, SP2, SP3 and SP4 may include, for example, silicon (Si), germanium (Ge), or silicon-germanium (SiGe), although embodiments are not limited thereto. For example, each of the first to fourth semiconductor patterns SP1, SP2, SP3 and SP4 may include crystalline silicon. Each of the first to fourth semiconductor patterns SP1, SP2, SP3 and SP4 may be a nanosheet.

A plurality of first source/drain patterns SD1 may be provided on the first insulating pattern AP1. A plurality of first recesses RS1 may be formed on the first insulating pattern AP1. The first source/drain patterns SD1 may be provided in the first recesses RS1, respectively. The first source/drain patterns SD1 may be dopant regions having a first conductivity type (e.g., a p-type). The first channel pattern CH1 may be disposed between a pair of the first source/drain patterns SD1. In other words, the first to fourth semiconductor patterns SP1, SP2, SP3 and SP4 stacked sequentially may connect the pair of first source/drain patterns SD1 to each other.

A plurality of second source/drain patterns SD2 may be provided on the second insulating pattern AP2. A plurality of second recesses RS2 may be formed on the second insulating pattern AP2. The second source/drain patterns SD2 may be provided in the second recesses RS2, respectively. The second source/drain patterns SD2 may be dopant regions having a second conductivity type (e.g., an n-type). The second channel pattern CH2 may be disposed between a pair of the second source/drain patterns SD2. In other words, the first to fourth semiconductor patterns SP1, SP2, SP3 and SP4 stacked sequentially may connect the pair of second source/drain patterns SD2 to each other.

The first and second source/drain patterns SD1 and SD2 may be epitaxial patterns formed by a selective epitaxial growth (SEG) process. For example, a top surface of each of the first and second source/drain patterns SD1 and SD2 may be located at substantially the same level as a top surface of the fourth semiconductor pattern SP4; that is, the top surface of each of the first and second source/drain patterns SD1, SD2 may be coplanar with the top surface of the fourth semiconductor pattern SP4 in the third direction D3. Alternatively, the top surface of each of the first and second source/drain patterns SD1 and SD2 may be higher than the top surface of the fourth semiconductor pattern SP4, with respect to the top surface of the substrate 105, in the third direction D3.

The first source/drain patterns SD1 may include a semiconductor material (e.g., SiGe) having a lattice constant greater than a lattice constant of a semiconductor material of the first channel pattern CH1. Thus, the pair of first source/drain patterns SD1 may provide compressive stress to the first channel pattern CH1 therebetween. The second source/drain patterns SD2 may include the same semiconductor material (e.g., Si) as the second channel pattern CH2.

Each of the first source/drain patterns SD1 may include a buffer layer BFL and a main layer MAL on the buffer layer BFL. Referring again to FIG. 5A, the buffer layer BFL may cover an inner surface of the first recess RS1. The main layer MAL may fill a remaining region of the first recess RS1 except the buffer layer BFL. A volume of the main layer MAL may be greater than a volume of the buffer layer BFL. Each of the buffer layer BFL and the main layer MAL may include silicon-germanium (SiGe), although embodiments are not limited thereto. More particularly, the buffer layer BFL may contain a relatively low concentration of germanium (Ge). In certain embodiments of the inventive concepts, the buffer layer BFL may contain silicon (Si) and not germanium (Ge). A concentration of germanium (Ge) of the buffer layer BFL may range from about 0 at% to 30 at%.

The main layer MAL may contain a relatively high concentration of germanium (Ge). For example, a concentration of germanium (Ge) in the main layer MAL may range from about 30 at% to 70 at%. The concentration of germanium (Ge) in the main layer MAL may increase with increasing distance toward an upper surface of the main layer MAL in the third direction D3. For example, the main layer MAL adjacent to the buffer layer BFL may have a germanium (Ge) concentration of about 40 at%, and an upper portion of the main layer MAL may have a germanium (Ge) concentration of about 60 at%.

Each of the buffer layer BFL and the main layer MAL may include dopants (e.g., boron, gallium, or indium) for allowing the first source/drain pattern SD1 to have the p-type conductivity. A concentration of the dopants of each of the buffer layer BFL and the main layer MAL may range from about 1E18 atom/cm³ to 5E22 atom/cm³. The concentration of the dopants of the main layer MAL may be greater than the concentration of the dopants of the buffer layer BFL.

The buffer layer BFL may protect the main layer MAL during a subsequent process of replacing second semiconductor layers SAL with first to third inner electrodes PO1, PO2 and PO3 of a gate electrode GE. In other words, the buffer layer BFL may prevent an etching material used to remove the second semiconductor layers SAL from permeating to the main layer MAL to etch it.

Each of the second source/drain patterns SD2 may include silicon (Si). The second source/drain pattern SD2 may further include dopants (e.g., phosphorus, arsenic, or antimony) for allowing the second source/drain pattern SD2 to have the n-type conductivity. A concentration of the dopants of the second source/drain pattern SD2 may range from about 1E18 atom/cm³ to 5E22 atom/cm³.

Gate electrodes GE may extend in the first direction D1 to intersect the first and second channel patterns CH1 and CH2. The gate electrodes GE may be arranged in the second direction D2 at a first pitch. Each of the gate electrodes GE may vertically overlap with the first and second channel patterns CH1 and CH2. The term "overlap" (or "overlapping," or like terms), as used herein, is intended to broadly refer to a first element that intersects with at least a portion of a second element in the vertical direction (i.e., third direction D3), but does not require that the first and second elements be completely aligned with one another in a horizontal plane (i.e., in the first direction D1 and/or second direction D2).

The gate electrode GE may include a first inner electrode PO1 disposed between the first semiconductor pattern SP1 and the second semiconductor pattern SP2, a second inner electrode PO2 disposed between the second semiconductor pattern SP2 and the third semiconductor pattern SP3, a third inner electrode PO3 disposed between the third semiconductor pattern SP3 and the fourth semiconductor pattern SP4, and an outer electrode PO4 on the fourth semiconductor pattern SP4.

According to the present embodiments, the dopant layer DEP may be disposed between the first semiconductor pattern SP1 and the silicon layer 100. A gate insulating layer GI may be disposed between the first to fourth semiconductor patterns SP1 to SP4 and the first to third inner electrodes PO1 to PO3. The gate insulating layer GI may not directly cover the dopant layer DEP.

Referring again to FIG. 5E, the gate electrode GE may be provided on a top surface TS, a bottom surface BS and both side surfaces SW of each of the first to fourth semiconductor patterns SP1, SP2, SP3 and SP4. In other words, the transistor according to the present embodiments may be a three-dimensional field effect transistor (e.g., a multi-bridge-channel field-effect transistor (MBCFET) or a gate-all-around field-effect transistor (GAAFET)) in which the gate electrode GE three-dimensionally surrounds (i.e., extends around) a channel.

For example, the first single height cell SHC1 may have a first boundary BD1 and a second boundary BD2, which are opposite to each other in the second direction D2. The first and second boundaries BD1 and BD2 may extend in the first direction D1. The first single height cell SHC1 may have a third boundary BD3 and a fourth boundary BD4, which are opposite to each other in the first direction D1. The third and fourth boundaries BD3 and BD4 may extend in the second direction D2.

Gate cutting patterns CT (FIG. 4) may be disposed on a boundary in the second direction D2 of each of the first and second single height cells SHC1 and SHC2. For example, the gate cutting patterns CT may be disposed on the third and fourth boundaries BD3 and BD4 of the first single height cell SHC1. The gate cutting patterns CT may be arranged along the third boundary BD3 at the first pitch. The gate cutting patterns CT may be arranged along the fourth boundary BD4 at the first pitch. The gate cutting patterns CT on the third and fourth boundaries BD3 and BD4 may overlap with the gate electrodes GE, respectively, when viewed in a plan view. The gate cutting patterns CT may include an insulating material such as silicon oxide, silicon nitride or a combination thereof.

The gate electrode GE on the first single height cell SHC1 may be separated from the gate electrode GE on the second single height cell SHC2 by the gate cutting pattern CT. The gate cutting pattern CT may be disposed between the gate electrode GE on the first single height cell SHC1 and the gate electrode GE on the second single height cell SHC2, which are aligned with each other in the first direction D1. In other words, the gate electrode GE extending in the first direction D1 may be divided into a plurality of the gate electrodes GE by the gate cutting patterns CT.

Referring again to FIGS. 4 and 5A to 5E, a pair of gate spacers GS may be disposed on opposing side surfaces of the outer electrode PO4 of the gate electrode GE, respectively, in the second direction D2. The gate spacers GS may extend along the gate electrode GE in the first direction D1. Top surfaces of the gate spacers GS may be higher, with respect to the top surface of the substrate 105, than a top surface of the gate electrode GE. The top surfaces of the gate spacers GS may be coplanar with a top surface of a first interlayer insulating layer 110 to be described later. The gate spacers GS may include at least one of SiCN, SiCON, or SiN, although embodiments are not limited thereto. For certain examples, each of the gate spacers GS may include a multi-layer formed of at least two of SiCN, SiCON, or SiN.

A gate capping pattern GP may be provided on the gate electrode GE. The gate capping pattern GP may extend along the gate electrode GE in the first direction D1. The gate capping pattern GP may include a material having an etch selectivity with respect to first and second interlayer insulating layers 110 and 120 to be described later. For example, the gate capping pattern GP may include at least one of SiON, SiCN, SiCON, or SiN.

The gate insulating layer GI may be disposed between the gate electrode GE and the first channel pattern CH1 and between the gate electrode GE and the second channel pattern CH2. The gate insulating layer GI may cover the top surface TS, the bottom surface BS and both side surfaces SW of each of the first to fourth semiconductor patterns SP1, SP2, SP3 and SP4. The gate insulating layer GI may cover a top surface of the device isolation layer ST under the gate electrode GE.

In some embodiments, the gate insulating layer GI may include a silicon oxide layer, a silicon oxynitride layer, and/or a high-k (i.e., high dielectric constant) dielectric layer. The high-k dielectric layer may include a high-k dielectric material of which a dielectric constant is higher than that of a silicon oxide layer. For example, the high-k dielectric material may include at least one of hafnium oxide, hafnium silicon oxide, hafnium zirconium oxide, hafnium tantalum oxide, lanthanum oxide, zirconium oxide, zirconium silicon oxide, tantalum oxide, titanium oxide, barium strontium titanium oxide, barium titanium oxide, strontium titanium oxide, lithium oxide, aluminum oxide, lead scandium tantalum oxide, or lead zinc niobate.

The gate electrode GE may include a first metal pattern and a second metal pattern on the first metal pattern. The first metal pattern may be provided on the gate insulating layer GI and may be adjacent to the first to fourth semiconductor patterns SP1, SP2, SP3 and SP4. The first metal pattern may include a work function metal configured for adjusting a threshold voltage of a transistor. A desired threshold voltage of the transistor may be obtained by adjusting a cross-sectional thickness and a composition of the first metal pattern. For example, the first to third inner electrodes PO1, PO2 and PO3 of the gate electrode GE may be formed of the first metal pattern corresponding to the work function metal.

The first metal pattern may include a metal nitride layer. For example, the first metal pattern may include nitrogen (N) and at least one metal selected from a group consisting of titanium (Ti), tantalum (Ta), aluminum (Al), tungsten (W), and molybdenum (Mo). In addition, the first metal pattern may further include carbon (C). In some embodiments, the first metal pattern may include a plurality of stacked work function metal layers.

The second metal pattern may include a metal having a resistance lower than that of the first metal pattern. For example, the second metal pattern may include at least one metal selected from a group consisting of tungsten (W), aluminum (Al), titanium (Ti), and tantalum (Ta). For example, the outer electrode PO4 of the gate electrode GE may include the first metal pattern and the second metal pattern on the first metal pattern.

Referring again to FIG. 5B, inner spacers IP may be provided on the first and second NMOSFET regions NR1 and NR2. In other words, the inner spacers IP may be provided on the second insulating pattern AP2. The inner spacers IP may be disposed between the second source/drain pattern SD2 and the first to third inner electrodes PO1, PO2 and PO3 of the gate electrode GE, respectively. The inner spacers IP may be in direct contact with the second source/drain pattern SD2. Each of the first to third inner electrodes PO1, PO2 and PO3 of the gate electrode GE may be spaced apart from the second source/drain pattern SD2 by the inner spacer IP.

A first interlayer insulating layer 110 may be provided on the substrate 105. The first interlayer insulating layer 110 may cover the gate spacers GS and the first and second source/drain patterns SD1 and SD2. A top surface of the first interlayer insulating layer 110 may be substantially coplanar with the top surface of the gate capping pattern GP and the top surface of the gate spacer GS in the third direction D3. A second interlayer insulating layer 120 covering the gate capping pattern GP may be disposed on the first interlayer insulating layer 110. A third interlayer insulating layer 130 may be provided on the second interlayer insulating layer 120. A fourth interlayer insulating layer 140 may be provided on the third interlayer insulating layer 130. For example, each of the first to fourth interlayer insulating layers 110 to 140 may include a silicon oxide layer.

A pair of isolation structures DB opposite to each other in the second direction D2 may be provided at both sides of each of the first and second single height cells SHC1 and SHC2. For example, the pair of isolation structures DB may be provided on the first and second boundaries BD1 and BD2 of the first single height cell SHC1, respectively. The isolation structures DB may extend in the first direction D1 in parallel to the gate electrode GE. A pitch between the isolation structure DB and the gate electrode GE adjacent thereto may be equal to the first pitch.

Each of the isolation structures DB may penetrate (i.e., extend at least partially into) the gate capping pattern GP and the gate electrode GE and may extend into the first and second insulating patterns AP1 and AP2. The isolation structure DB may penetrate an upper portion of each of the first and second insulating patterns AP1 and AP2. The isolation structure DB may penetrate the dopant layer DEP. The isolation structure DB may electrically isolate an active region (e.g., the PMOSFET and NMOSFET regions) of each of the first and second single height cells SHC1 and SHC2 from an active region of another cell adjacent thereto.

Active contacts AC may penetrate (i.e., extend at least partially into) the first and second interlayer insulating layers 110 and 120 so as to be electrically connected to the first and second source/drain patterns SD1 and SD2. The term "connected," as may be used herein, is intended to refer to an electrical and/or physical connection between two or more elements, and may include other intervening elements. Each of the active contacts AC may be provided adjacent to a side of the gate electrode GE. The active contact AC may have a bar shape extending in the first direction D1 when viewed in a plan view.

The active contact AC may be a self-aligned contact. In other words, the active contact AC may be formed to be self-aligned with the gate capping pattern GP and the gate spacer GS. For example, the active contact AC may cover at least a portion of a side surface of the gate spacer GS. Even though not shown in the drawings, the active contact AC may cover a portion of the top surface of the gate capping pattern GP.

Metal-semiconductor compound layers SC (e.g., silicide layers) may be disposed between the active contact AC and the first source/drain pattern SD1 and between the active contact AC and the second source/drain pattern SD2, respectively. The active contact AC may be electrically connected to the source/drain pattern SD1 or SD2 through the metal-semiconductor compound layer SC. For example, the metal-semiconductor compound layer SC may include at least one of titanium silicide, tantalum silicide, tungsten silicide, nickel silicide, or cobalt silicide, although embodiments are not limited thereto.

Gate contacts GC may penetrate the second interlayer insulating layer 120 and the gate capping patterns GP so as to be electrically connected to the gate electrodes GE, respectively. Two gate contacts GC on the first single height cell SHC1 may overlap with the first PMOSFET region PR1 when viewed in a plan view. In other words, the two gate contacts GC on the first single height cell SHC1 may be provided on the first insulating pattern AP1 (see FIG. 5A). One gate contact GC on the first single height cell SHC1 may overlap with the first NMOSFET region NR1 when viewed in a plan view. In other words, the one gate contact GC on the first single height cell SHC1 may be provided on the second insulating pattern AP2 (see FIG. 5B).

The gate contact GC may be freely disposed on the gate electrode GE regardless of its position. For example, the gate contacts GC on the second single height cell SHC2 may be disposed on the second PMOSFET region PR2, the second NMOSFET region NR2 and the device isolation layer ST filling the trench TR, respectively (see FIG. 4).

In some embodiments of the inventive concepts, referring in particular to FIG. 5B, an upper portion of the active contact AC adjacent to the gate contact GC may be filled with an upper insulating pattern UIP. A bottom surface of the upper insulating pattern UIP may be lower than a bottom surface of the gate contact GC in the third direction D3, relative to the top surface of the substrate 105. In other words, a top surface of the active contact AC adjacent to the gate contact GC may be lower than the bottom surface of the gate contact GC, in the third direction D3, due to the upper insulating pattern UIP. Thus, it is possible to prevent an electrical short between the gate contact GC and the active contact AC adjacent thereto. For example, the upper insulating pattern UIP may include a silicon-based insulating material (e.g., silicon oxide, silicon nitride, or silicon oxynitride).

Each of the active contact AC and the gate contact GC may include a conductive pattern FM and a barrier pattern BM surrounding the conductive pattern FM. For example, the conductive pattern FM may comprise a metal, including at least one of aluminum, copper, tungsten, molybdenum, or cobalt. The barrier pattern BM may cover side surfaces and a bottom surface of the conductive pattern FM. The barrier pattern BM may include a metal layer/a metal nitride layer. The metal layer may include at least one of titanium, tantalum, tungsten, nickel, cobalt, or platinum. The metal nitride layer may include at least one of a titanium nitride (TiN) layer, a tantalum nitride (TaN) layer, a tungsten nitride (WN) layer, a nickel nitride (NiN) layer, a cobalt nitride (CoN) layer, or a platinum nitride (PtN) layer.

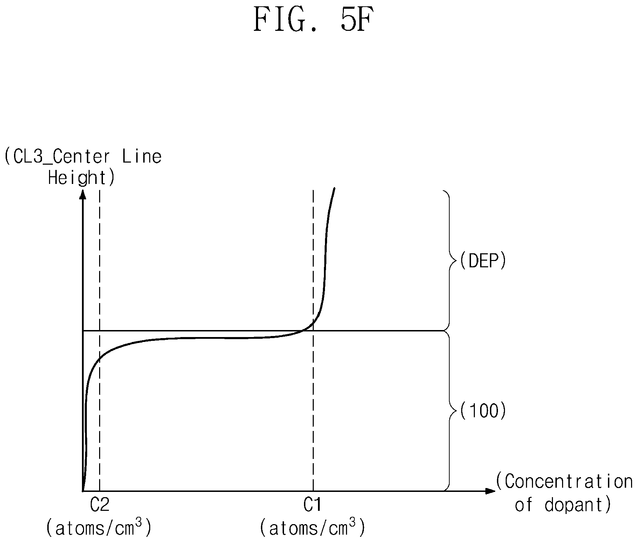

Referring to FIGS. 5B and 5F, the dopant layer DEP may have a first center line CL1. The gate electrode GE may have a second center line CL2. The dopant layer DEP and the silicon layer 100 may have a third center line CL3. The first to third center lines CL1, CL2 and CL3 may be defined as lines showing center positions in the second direction D2 in the dopant layer DEP, the gate electrode GE and the silicon layer 100, respectively.

The first center line CL1 and the second center line CL2 may be vertically aligned with each other (i.e., aligned in the third direction D3). In other words, the first center line CL1 and the second center line CL2 may have the same position in the second direction D2. Thus, the dopant layer DEP and the gate electrode GE may not be offset from each other but may vertically overlap with each other. More particularly, the dopant layer DEP may not be offset from the first to third inner electrodes PO1 to PO3 and the outer electrode PO4 but may vertically overlap with the first to third inner electrodes PO1 to PO3 and the outer electrode PO4. The dopant layer DEP may not be offset from the first to fourth semiconductor patterns SP1 to SP4 disposed between the first to third inner electrodes PO1 to PO3 and the outer electrode PO4 but may vertically overlap with the first to fourth semiconductor patterns SP1 to SP4. In other words, the dopant layer DEP may vertically overlap with the channel pattern CH1 or CH2.

Referring to a graph of FIG. 5F, a dopant concentration in the silicon layer 100 and the dopant layer DEP according to the third center line CL3 is shown. A first dopant concentration C1 of the dopant layer DEP may be greater than a second dopant concentration C2 of the silicon layer 100. In a method of manufacturing a semiconductor device, an EPI (epitaxial) process may be performed on the silicon layer 100. The EPI process may be a process of EPI-growing a silicon-based layer including a dopant. For example, a silicon layer (Si-layer) including fluorine (F) as the dopant may be grown to form the dopant layer DEP.

The concentration of the dopant in the dopant layer DEP may be exponentially reduced toward the silicon layer 100. In this case, the exponential reduction may mean that the dopant concentration is rapidly reduced at an interface of the dopant layer DEP and the silicon layer 100. The concentration of the dopant in the silicon layer 100 may converge to zero (0) toward the substrate 105.

Referring again to FIGS. 4 and 5A to 5E, first to third lower power interconnection lines VPR1, VPR2 and VPR3 may be provided in a lower portion of the substrate 105. The first to third lower power interconnection lines VPR1, VPR2 and VPR3 may extend in the second direction D2 in parallel to each other. The first lower power interconnection line VPR1 may be disposed on the fourth boundary BD4 of the first single height cell SHC1. The second lower power interconnection line VPR2 may be disposed on the third boundary BD3 of the first single height cell SHC1. In other words, the first single height cell SHC1 may be defined between the first lower power interconnection line VPR1 and the second lower power interconnection line VPR2. The second single height cell SHC2 may be defined between the second lower power interconnection line VPR2 and the third lower power interconnection line VPR3. More particularly, the second lower power interconnection line VPR2 may overlap with a boundary of the first and second single height cells SHC1 and SHC2.

In some embodiments of the inventive concepts, the first lower power interconnection line VPR1 may vertically overlap with the first NMOSFET region NR1. The second lower power interconnection line VPR2 may vertically overlap with the first PMOSFET region PR1 and the second PMOSFET region PR2. The third lower power interconnection line VPR3 may vertically overlap with the second NMOSFET region NR2.

The first to third lower power interconnection lines VPR1 to VPR3 may include at least one material selected from a group consisting of copper, molybdenum, tungsten, and ruthenium. A bottom surface of each of the first to third lower power interconnection lines VPR1 to VPR3 may be coplanar with a bottom surface of the substrate 105 in the third direction D3.

A power delivery network layer PDN may be provided on the bottom surface of the substrate 105. The power delivery network layer PDN may include a plurality of lower interconnection lines electrically connected to the first to third lower power interconnection lines VPR1 to VPR3. For example, the power delivery network layer PDN may include an interconnection network for applying a source voltage VSS to the first and third lower power interconnection lines VPR1 and VPR3. The power delivery network layer PDN may include an interconnection network for applying a drain voltage VDD to the second lower power interconnection line VPR2.

Referring again to FIGS. 4, 5A, 5B and 5D, a first backside contact BDC1 may penetrate the substrate 105 to vertically extend from the second lower power interconnection line VPR2 to the first source/drain pattern SD1. A second backside contact BDC2 may penetrate the substrate 105 to vertically extend from the first lower power interconnection line VPR1 to the second source/drain pattern SD2.

The first backside contact BDC1 may have a conductive pillar shape vertically and electrically connecting the second lower power interconnection line VPR2 to the first source/drain pattern SD1. The drain voltage VDD may be applied to the first source/drain pattern SD1 through the first backside contact BDC1.

The second backside contact BDC2 may have a conductive pillar shape vertically and electrically connecting the first lower power interconnection line VPR1 to the second source/drain pattern SD2. The source voltage VSS may be applied to the second source/drain pattern SD2 through the second backside contact BDC2.

The first and second backside contacts BDC1 and BDC2 may penetrate (i.e., extend into) the substrate 105 and the silicon layer 100. The first and second backside contacts BDC1 and BDC2 may electrically connect the lower power interconnection lines VPR1 to VPR3 to the first and second source/drain patterns SD1 and SD2. A side surface of each of the first and second backside contacts BDC1 and BDC2 may be in contact with the silicon layer 100 and the first buried spacer BSP1.

Each of the first and second backside contacts BDC1 and BDC2 may include a contact plug PCP connected to the lower power interconnection line VPR1, VPR2 or VPR3, a contact portion SEC on the contact plug PCP, and a metal-semiconductor compound layer SC between the contact portion SEC and the source/drain pattern SD1 or SD2. The contact portion SEC may be connected to the source/drain pattern SD1 or SD2 through the metal-semiconductor compound layer SC. A liner pattern LIN may be disposed between each of the first and second backside contacts BDC1 and BDC2 and the first buried spacer BSP1 and between each of the first and second backside contacts BDC1 and BDC2 and the silicon layer 100. In other words, the liner pattern LIN may be provided on side surfaces of the contact portion SEC and the contact plug PCP.

The contact plug PCP may be connected to each of the lower power interconnection lines VPR1 to VPR3. More particularly, the contact plug PCP may be connected to each of the lower power interconnection lines VPR1 to VPR3 through a via portion VVI of each of the lower power interconnection lines VPR1 to VPR3. A width of the via portion VVI in the second direction D2 may become progressively greater toward the lower power interconnection line VPR1, VPR2 or VPR3; that is, sidewalls of the via portion VVI may be outwardly sloped from a top surface to a bottom surface of the via portion VVI, such that a width in the first direction D1 at the top surface of the via portion VVI is greater than a width in the first direction D1 at the bottom surface of the via portion VVI. The via portion VVI may vertically overlap with the contact plug PCP and the contact portion SEC. The via portion VVI may vertically overlap with the contact portion SEC and the first buried spacer BSP1. More particularly, the via portion VVI may vertically overlap with the contact portion SEC and a portion of the first buried spacer BSP1.

A width of the contact plug PCP in the second direction D2 may be less than a width of the contact portion SEC in the second direction D2. The width of the contact portion SEC in the second direction D2 may gradually increase and then decrease as a vertical distance from the substrate 105 increases.

Both side surfaces of the contact portion SEC may be curved surfaces. Each of both side surfaces of the contact portion SEC may have a curved surface shape corresponding to the first side surface SW1 of the first buried spacer BSP1. In other words, a curvature of each of the side surfaces of the contact portion SEC may be equal to the curvature of the first side surface SW1. The curvatures equal to each other may mean that a ratio of a curvature radius of the side surface of the contact portion SEC to the curvature radius of the first side surface SW1 ranges from about 0.9 to 1.1. In other words, when the curvature radius ratio ranges from about 0.9 to 1.1 or is 1.0, the curvature of the first side surface SW1 and the curvature of the side surface of the contact portion SEC may be substantially equal to each other. Each of both side surfaces of the contact portion SEC may be convex toward the first buried spacer BSP1.

The contact plug PCP and the contact portion SEC may include at least one metal selected from a group consisting of tungsten, molybdenum, ruthenium, cobalt, aluminum, and copper. Alternatively, the contact portion SEC may include a semiconductor material such as silicon (Si), germanium (Ge) or silicon-germanium (SiGe). The liner pattern LIN may include a silicon-based insulating material (e.g., SiO, SiN, SiOC, or SiOCN).

Referring again to FIGS. 4 and 5A to 5E, a first metal layer M1 may be provided in the third interlayer insulating layer 130. The first metal layer M1 may include first interconnection lines M1_I. The first interconnection lines M1_I of the first metal layer M1 may extend in the second direction D2 in parallel to each other.

According to the embodiments of the inventive concepts, power interconnection lines for supplying power to the single height cell SHC may be buried in the substrate 105 in the form of the lower power interconnection lines VPR1 to VPR3. Thus, the power interconnection lines may be omitted in the first metal layer M1. The first interconnection lines M1_I for transmitting signals may be disposed in the first metal layer M1.

The first metal layer M1 may further include first vias VI1. The first vias VI1 may be provided under the first interconnection lines M1_I of the first metal layer M1. The active contact AC may be electrically connected to a corresponding one of the first interconnection lines M1_I of the first metal layer M1 through a corresponding one of the first vias VI1. The gate contact GC may be electrically connected to a corresponding one of the first interconnection lines M1_I of the first metal layer M1 through a corresponding one of the first vias VI1.

The first interconnection line M1_I of the first metal layer M1 and the first via VI1 thereunder may be formed using different processes. In other words, each of the first interconnection line M1_I and the first via VI1 of the first metal layer M1 may be formed using a single damascene process. The semiconductor device according to the present embodiments may be formed using processes less than 20 nanometers (nm).

A second metal layer M2 may be provided in the fourth interlayer insulating layer 140. The second metal layer M2 may include a plurality of second interconnection lines M2_I. Each of the second interconnection lines M2_I of the second metal layer M2 may have a line shape or bar shape extending in the first direction D1. In other words, the second interconnection lines M2_I may extend in the first direction D1 in parallel to each other.

The second metal layer M2 may further include second vias VI2 provided under the second interconnection lines M2_I. The first interconnection lines M1_I of the first metal layer M1 may be electrically connected to a corresponding one of the second interconnection lines M2_I of the second metal layer M2 through a corresponding one of the second vias VI2. For example, the second interconnection line M2_I of the second metal layer M2 and the second via VI2 thereunder may be formed together using a dual damascene process.

The first interconnection line M1_I of the first metal layer M1 and the second interconnection line M2_I of the second metal layer M2 may include the same conductive material or different conductive materials. For example, the first interconnection line M1_I of the first metal layer M1 and the second interconnection line M2_I of the second metal layer M2 may include at least one of aluminum, copper, tungsten, molybdenum, ruthenium, and cobalt. Even though not shown in the drawings, metal layers (e.g., M3, M4, M5, ...) stacked on the fourth interlayer insulating layer 140 may be additionally provided. Each of the stacked metal layers may include interconnection lines for routing between cells.

The semiconductor device according to the embodiments of the inventive concepts may include the buried spacers BSP1 and BSP2, and thus a leakage current of the channel patterns CH1 and CH2 may be prevented. The leakage current may be generated when current carriers generated by a tunnel effect are moved through a silicon-based layer provided under the channel pattern CH1 or CH2. The buried spacers BSP1 and BSP2 may be barrier layers including an insulating material and provided between the silicon layer 100 and the channel patterns CH1 and CH2 and thus may prevent generation of the leakage current. In addition, the buried spacers BSP1 and BSP2 may prevent a short circuit phenomenon between the source/drain patterns SD1 and SD2. As a result, the buried spacers BSP1 and BSP2 may prevent the leakage current from the transistor to a semiconductor substrate and the short circuit phenomenon, and thus electrical characteristics of the semiconductor device may be improved.

In the semiconductor device according to embodiments of the inventive concepts, the buried spacers BSP1 and BSP2 may prevent a short circuit phenomenon occurring between the gate electrode GE and the backside contacts BDC1 and BDC2 connected to the source/drain patterns SD1 and SD2. As a result, the semiconductor device of the inventive concepts, to which the lower power interconnection lines are applied, may have improved electrical characteristics.

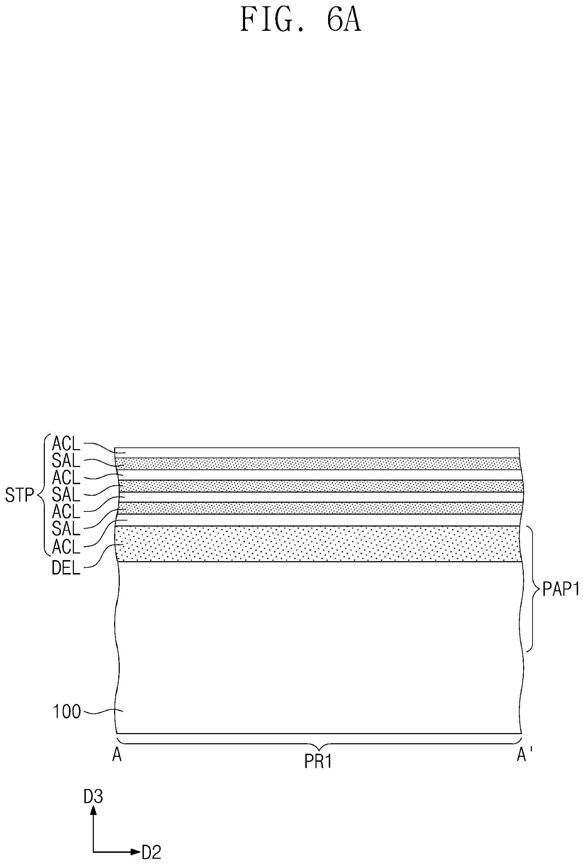

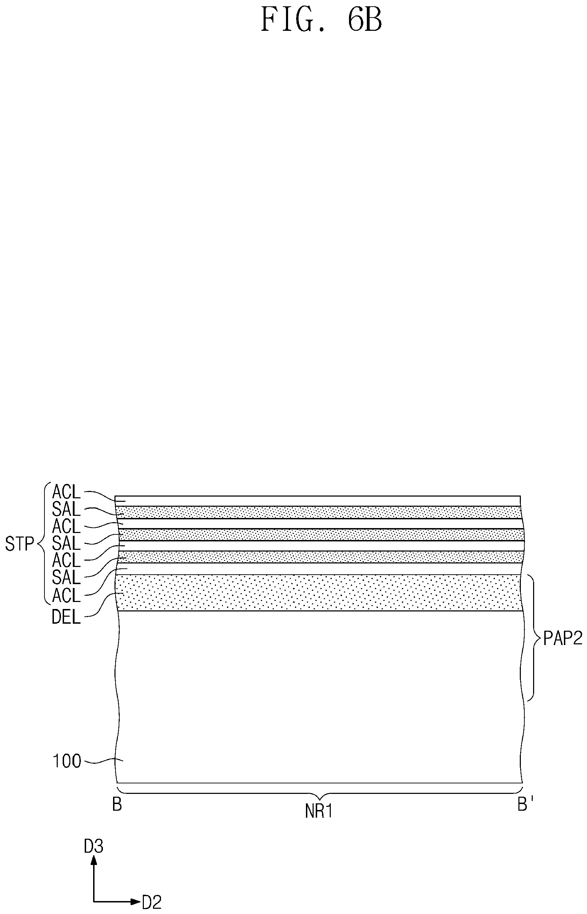

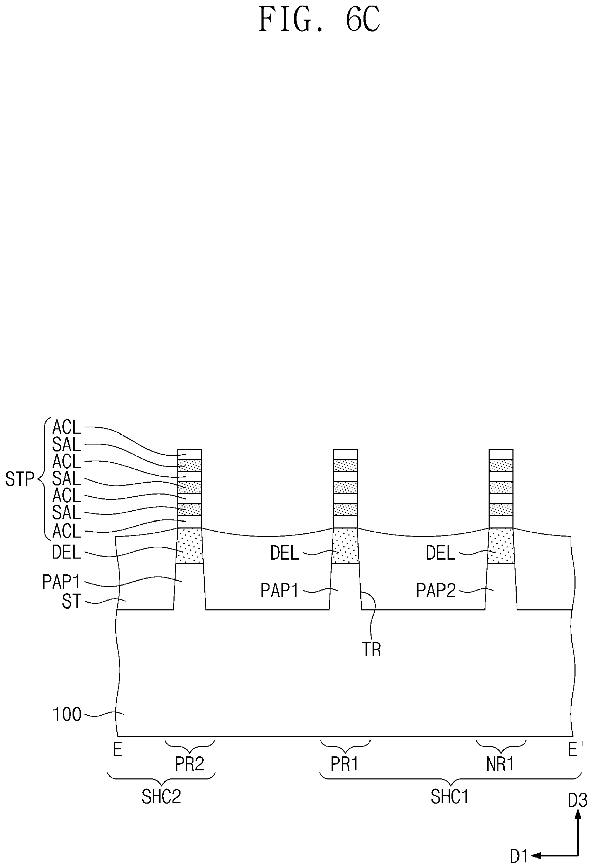

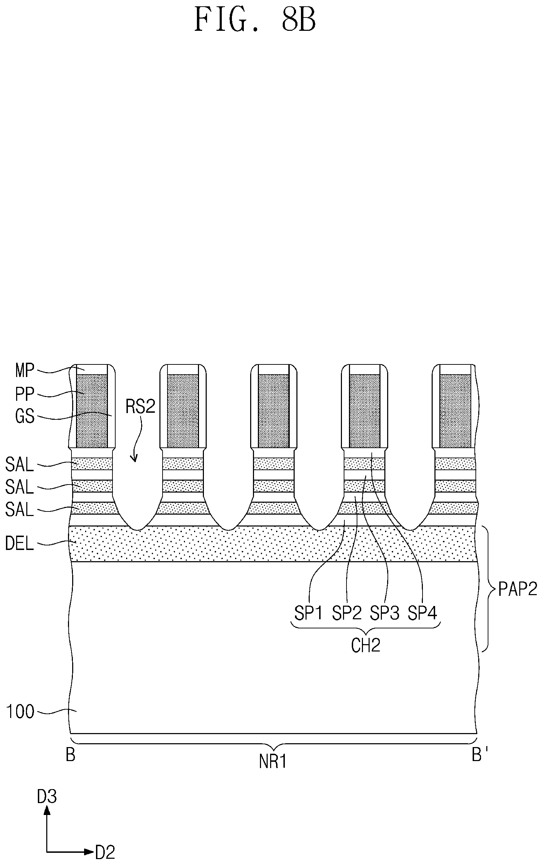

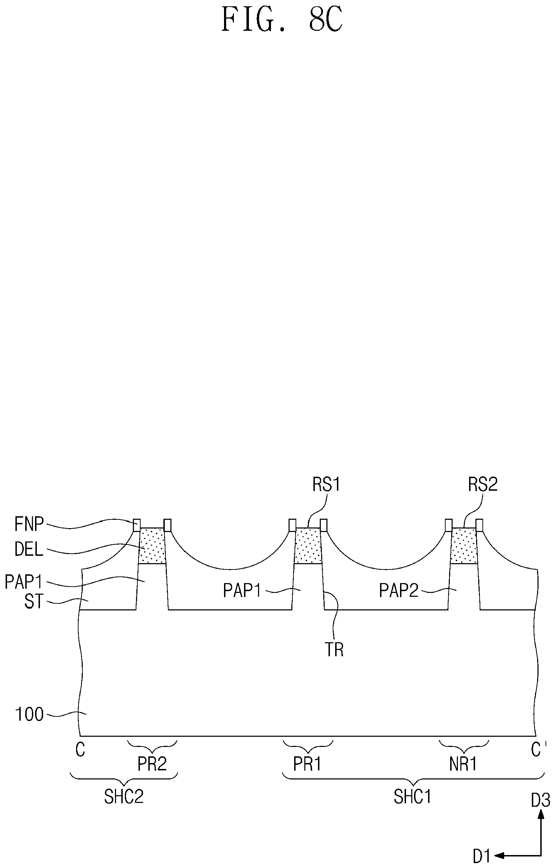

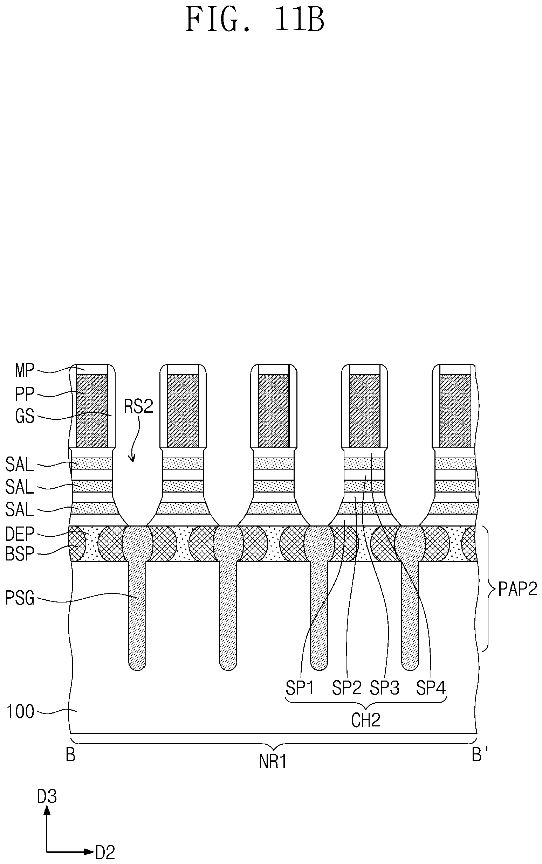

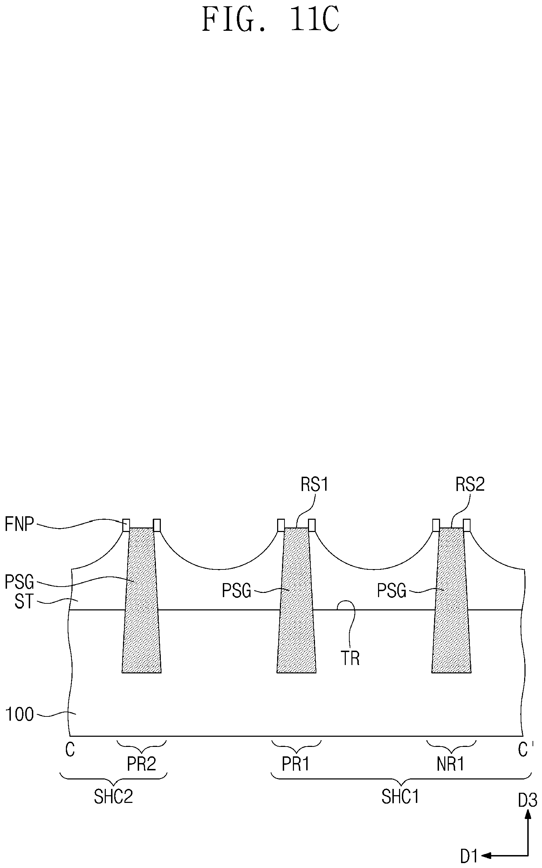

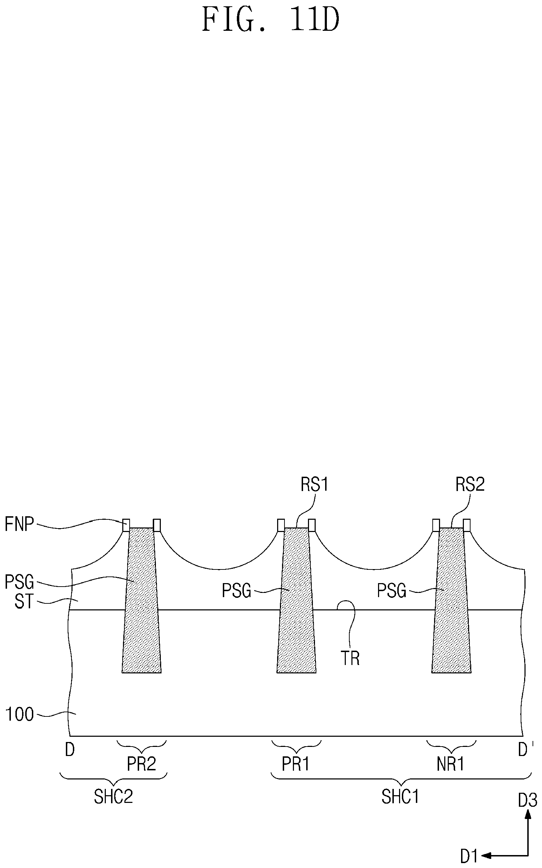

FIGS. 6A to 16D are cross-sectional views illustrating intermediate processes in an example method of manufacturing a semiconductor device, according to some embodiments of the inventive concepts. More particularly, FIGS. 6A, 7A, 8A, 9A, 10A, 11A, 12A, 13A, 14A, 15A and 16A are cross-sectional views corresponding to the line A-A' of FIG. 4. FIGS. 6B, 7B, 8B, 9B, 10B, 11B, 12B, 13B, 14B, 15B and 16B are cross-sectional views corresponding to the line B-B' of FIG. 4. FIGS. 8C, 11C, 12C, 13C, 14C, 15C and 16C are cross-sectional views corresponding to the line C-C' of FIG. 4. FIGS. 11D, 14D, 15D and 16D are cross-sectional views corresponding to the line D-D' of FIG. 4. FIGS. 6C, 7C, 13D and 14E are cross-sectional views corresponding to the line E-E' of FIG. 4.

Referring to FIGS. 6A to 6C, a semiconductor substrate 100 including first and second PMOSFET regions PR1 and PR2 and first and second NMOSFET regions NR1 and NR2 may be provided. For example, the semiconductor substrate 100 may be a silicon wafer. A preliminary dopant layer DEL including a dopant may be formed on the semiconductor substrate 100. The preliminary dopant layer DEL may be a doped-Si layer based on the silicon wafer.

For example, the formation of the preliminary dopant layer DEL may include performing a selective epitaxial growth (SEG) process on the semiconductor substrate 100. Dopants (e.g., fluorine (F), argon (Ar), oxygen (O), nitrogen (N) or any combination thereof) may be injected (e.g., using an implantation process) in-situ during the SEG process. The preliminary dopant layer DEL formed on the semiconductor substrate 100 may include silicon doped with fluorine (F), argon (Ar), oxygen (O), nitrogen (N) or any combination thereof. A concentration of the dopants (e.g., oxygen, carbon or any combination thereof) in the preliminary dopant layer DEL may range from about 0.5 at% to 2 at%.

First semiconductor layers ACL and second semiconductor layers SAL may be alternately formed on the preliminary dopant layer DEL in the third (i.e., vertical) direction D3. The first semiconductor layers ACL may include one of silicon (Si), germanium (Ge) and silicon-germanium (SiGe), and the second semiconductor layers SAL may include another of silicon (Si), germanium (Ge) and silicon-germanium (SiGe), although embodiments are not limited thereto.

The second semiconductor layers SAL may include a material having an etch selectivity with respect to the first semiconductor layers ACL. For example, the first semiconductor layers ACL may include silicon (Si), and the second semiconductor layers SAL may include silicon-germanium (SiGe). A concentration of germanium (Ge) of each of the second semiconductor layers SAL may range from about 10 at% to 50 at%.

Mask patterns may be formed on the first and second PMOSFET regions PR1 and PR2 and the first and second NMOSFET regions NR1 and NR2 of the semiconductor substrate 100, respectively. Each of the mask patterns may have a line shape or bar shape extending in the second direction D2.

A patterning process may be performed using the mask patterns as etch masks to form a trench TR defining first active patterns PAP1 and second active patterns PAP2. The first active patterns PAP1 may be formed on each of the first and second PMOSFET regions PR1 and PR2. The second active patterns PAP2 may be formed on each of the first and second NMOSFET regions NR1 and NR2. The first and second active patterns PAP1 and PAP2 may have line shapes extending in the second direction D2 in parallel to each other when viewed in a plan view.

A stack pattern STP may be formed on each of the first and second active patterns PAP1 and PAP2. The stack pattern STP may include the first semiconductor layers ACL and the second semiconductor layers SAL, which are alternately stacked on the preliminary dopant layer DEL in the third direction D3. The stack patterns STP may be formed together with the first and second active patterns PAP1 and PAP2 in the patterning process.

A device isolation layer ST at least partially filling the trench TR may be formed. For example, an insulating layer covering the first and second active patterns PAP1 and PAP2 and the stack patterns STP may be formed on an entire top surface of the semiconductor substrate 100 (e.g., using a blanket deposition process). The insulating layer may be recessed until the stack patterns STP are exposed, thereby forming the device isolation layer ST.

The device isolation layer ST may include an insulating material (e.g., silicon oxide). The stack patterns STP may be exposed above the device isolation layer ST in the third direction D3. In other words, the stack patterns STP may vertically protrude above the device isolation layer ST.

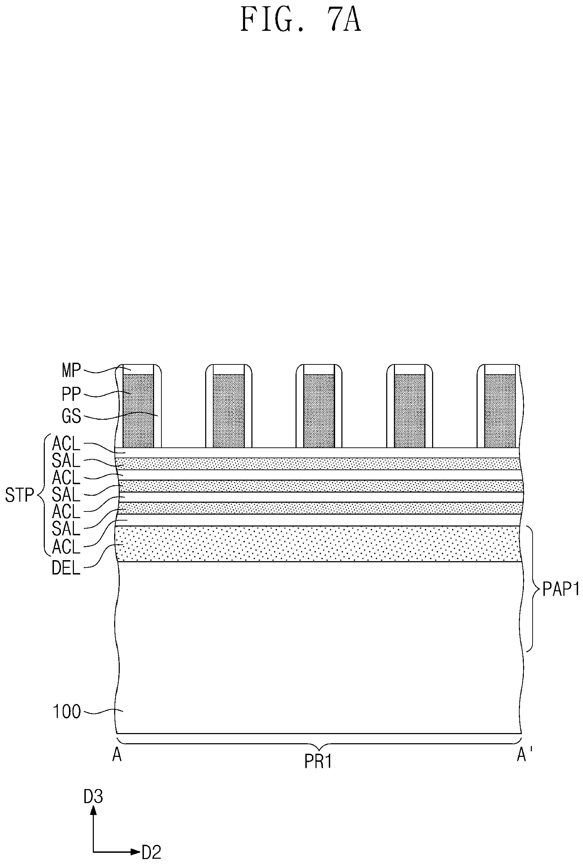

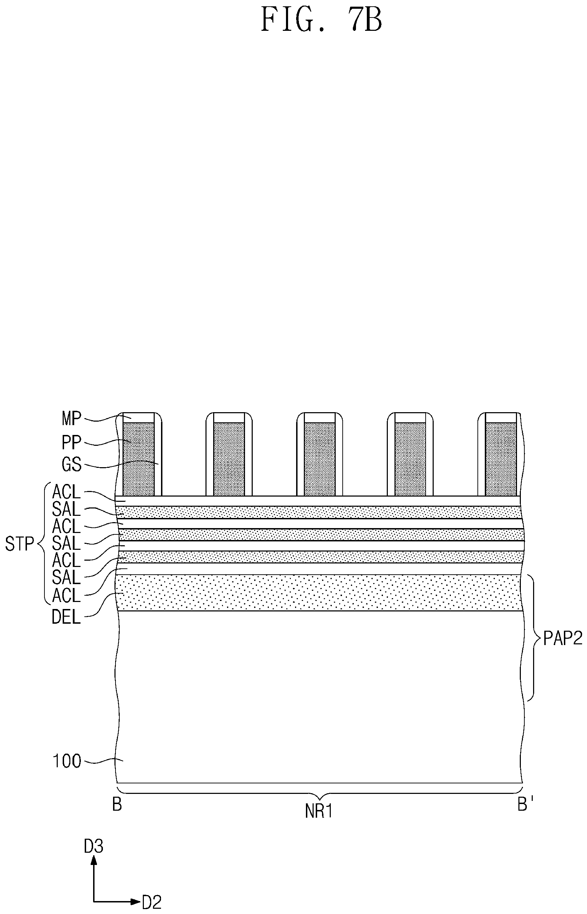

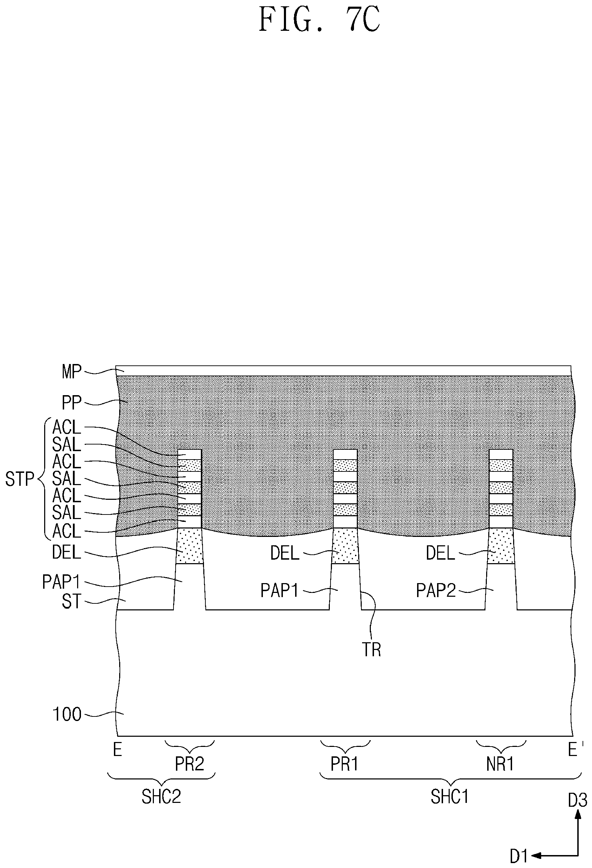

Referring to FIGS. 7A to 7C, sacrificial patterns PP intersecting the stack patterns STP may be formed on the semiconductor substrate 100. Each of the sacrificial patterns PP may be formed to have a line shape or bar shape extending in the first direction D1. The sacrificial patterns PP may be arranged at a first pitch in the second direction D2.

For example, the formation of the sacrificial patterns PP may include forming a sacrificial layer on an entire top surface of the semiconductor substrate 100, forming hard mask patterns MP on the sacrificial layer, and patterning the sacrificial layer using the hard mask patterns MP as etch masks. The sacrificial layer may include poly-silicon.

A pair of gate spacers GS may be formed on both (opposing) side surfaces of each of the sacrificial patterns PP, respectively. The formation of the gate spacers GS may include conformally forming a gate spacer layer on an entire top surface of the semiconductor substrate 100, and anisotropically etching the gate spacer layer. The gate spacer layer may include at least one of SiCN, SiCON, or SiN. In certain embodiments, the gate spacer layer may be formed of a multi-layer including at least two of SiCN, SiCON, or SiN, although embodiments are not limited thereto.

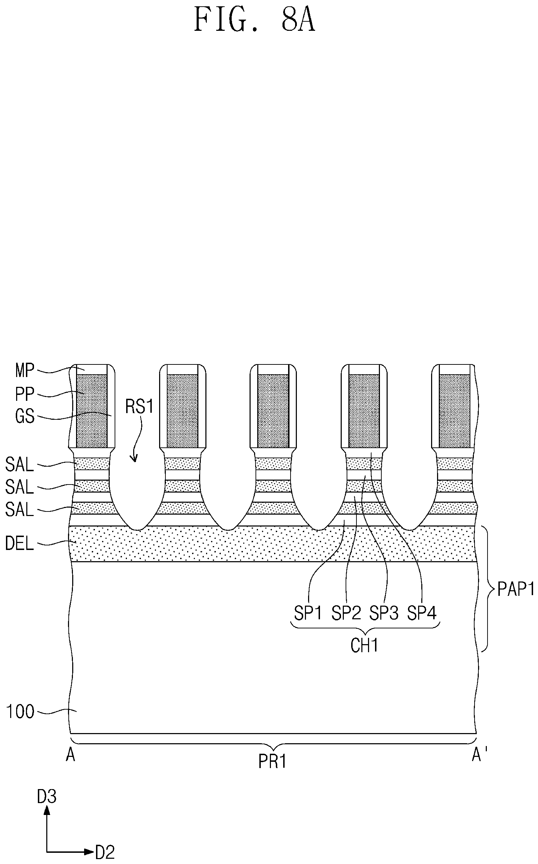

Referring to FIGS. 8A to 8C, first recesses RS1 may be formed in the stack pattern STP on the first active pattern PAP1. Second recesses RS2 may be formed in the stack pattern STP on the second active pattern PAP2. The first and second recesses RS1 and RS2 may extend vertically (i.e., in the third direction D3) through the stack pattern STP and at least partially into an upper portion of the underlying preliminary dopant layer DEL. The device isolation layer ST at both sides of each of the first and second active patterns PAP1 and PAP2 may be further recessed during the formation of the first and second recesses RS1 and RS2 (see FIG. 8C).

More particularly, the stack pattern STP on the first active pattern PAP1 may be etched using the hard mask patterns MP and the gate spacers GS as etch masks to form the first recesses RS1. The first recess RS1 may be formed between a pair of the sacrificial patterns PP. The second recesses RS2 in the stack pattern STP on the second active pattern PAP2 may be formed by the same method as the first recesses RS 1.

Referring again to FIG. 8C, a fence pattern FNP may be formed on each of the first and second active patterns PAP1 and PAP2. The fence pattern FNP may be a remaining portion of the gate spacer GS.

Referring again to FIGS. 8A to 8C, first to fourth semiconductor patterns SP1, SP2, SP3 and SP4 stacked sequentially in the third direction D3 may be formed from the first semiconductor layers ACL between the first recesses RS1 adjacent to each other. First to fourth semiconductor patterns SP1, SP2, SP3 and SP4 stacked sequentially in the third direction D3 may be formed from the first semiconductor layers ACL between the second recesses RS2 adjacent to each other. The first to fourth semiconductor patterns SP1, SP2, SP3 and SP4 between the first recesses RS1 adjacent to each other may constitute a first channel pattern CH1. The first to fourth semiconductor patterns SP1, SP2, SP3 and SP4 between the second recesses RS2 adjacent to each other may constitute a second channel pattern CH2.

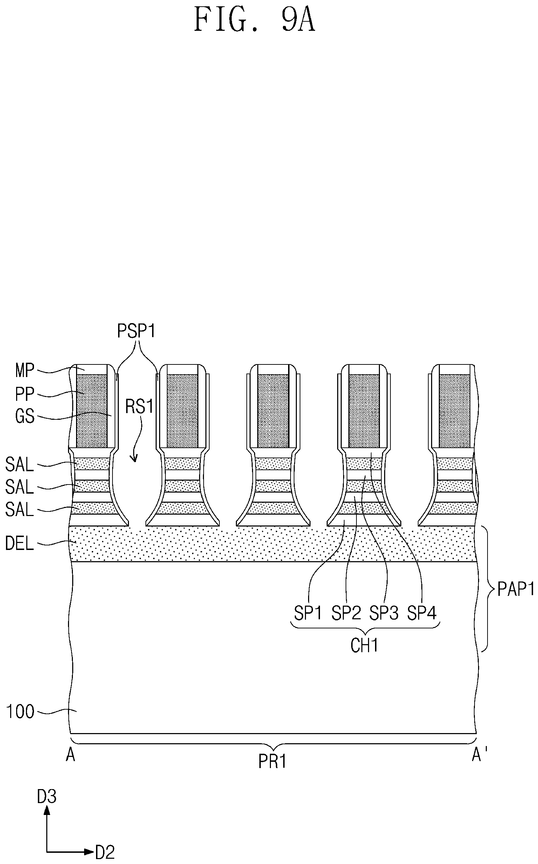

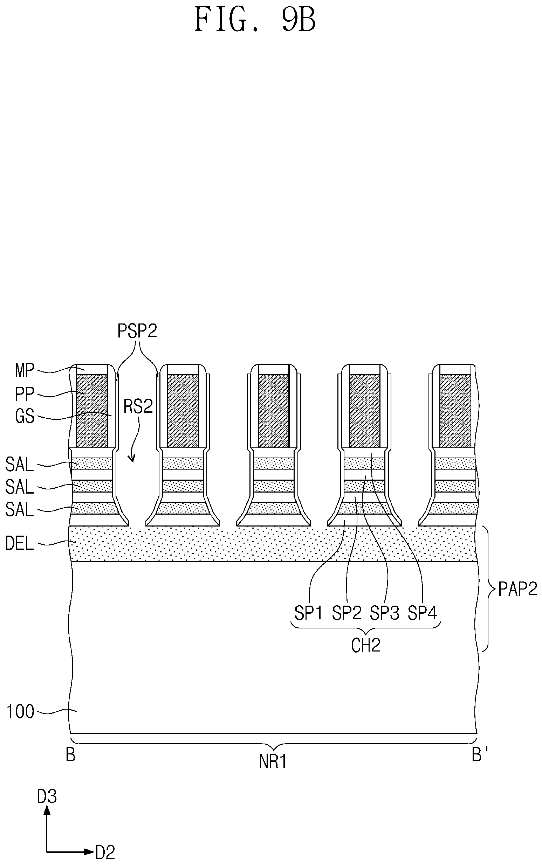

Referring to FIGS. 9A and 9B, a first sacrificial spacer PSP1 may be formed in each of the first recesses RS1. The first sacrificial spacer PSP1 may be formed along an inner side surface of the first recess RS1. The first sacrificial spacer PSP1 may extend from the inner side surface of the first recess RS1 onto a side surface of the gate spacer GS. The first sacrificial spacer PSP1 may prevent a loss of the first to fourth semiconductor patterns SP1, SP2, SP3 and SP4 and the second semiconductor layers SAL when an etching process to be described later is performed. A top surface of the first sacrificial spacer PSP1 may be located at substantially the same level in the third direction D3 as a top surface of the sacrificial pattern PP (i.e., coplanar).

A second sacrificial spacer PSP2 may be formed in each of the second recesses RS2. The second sacrificial spacer PSP2 may be formed along an inner side surface of the second recess RS2. The second sacrificial spacer PSP2 may extend from the inner side surface of the second recess RS2 onto the side surface of the gate spacer GS. The second sacrificial spacer PSP2 may prevent a loss of the first to fourth semiconductor patterns SP1, SP2, SP3 and SP4 and the second semiconductor layers SAL when an etching process to be described later is performed. A top surface of the second sacrificial spacer PSP2 may be located at substantially the same level in the third direction D3 as the top surface of the sacrificial pattern PP.

A pair of the first or second sacrificial spacers PSP1 or PSP2 may be formed on the inner side surfaces of the first or second recess RS1 or RS2. The formation of the first and second sacrificial spacers PSP1 and PSP2 may include conformally forming a sacrificial spacer layer on an entire top surface of the semiconductor substrate 100 (e.g., blanket deposition), and anisotropically etching the sacrificial spacer layer (e.g., by an etch-back process). The etched sacrificial spacer layer may be the first and second sacrificial spacers PSP1 and PSP2. In other words, the first and second sacrificial spacers PSP1 and PSP2 may not be formed on the preliminary dopant layer DEL.

The first and second sacrificial spacers PSP1 and PSP2 may include silicon oxide or silicon nitride. For example, the first and second sacrificial spacers PSP1 and PSP2 may include at least one of SiO, SiCN, SiCON, or SiN. The first and second sacrificial spacers PSP1 and PSP2 may have an etch selectivity with respect to the preliminary dopant layer DEL. For some examples, in the case in which the preliminary dopant layer DEL includes silicon doped with fluorine (F), argon (Ar), oxygen (O) or any combination thereof, the first and second sacrificial spacers PSP1 and PSP2 may include silicon nitride. For certain examples, in the case in which the preliminary dopant layer DEL includes silicon doped with nitrogen (N), the first and second sacrificial spacers PSP1 and PSP2 may include silicon oxide.

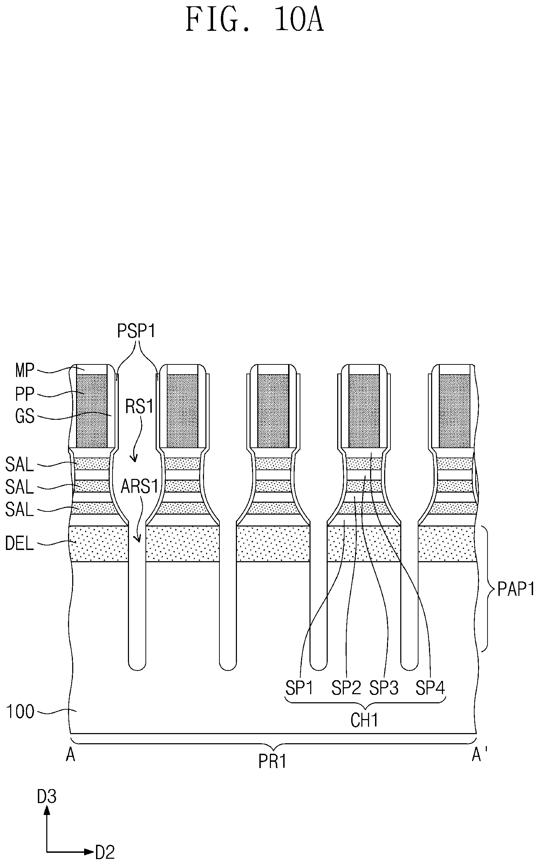

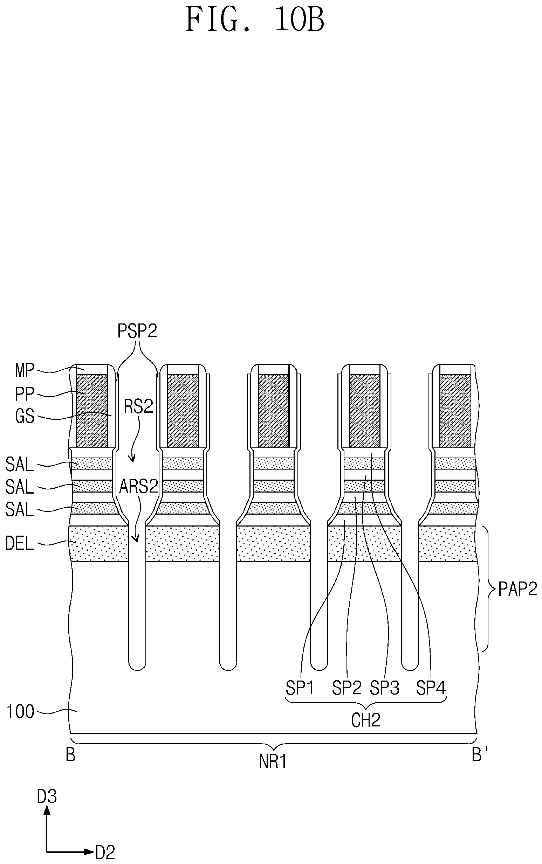

Referring to FIGS. 10A and 10B, an etching process may be performed using the hard mask patterns MP and the first and second sacrificial spacers PSP1 and PSP2 as etch masks, thereby forming third recesses ARS1 and fourth recesses ARS2. The third recesses ARS1 may be formed in the preliminary dopant layer DEL and the first active pattern PAP1. The fourth recesses ARS2 may be formed in the preliminary dopant layer DEL and the second active pattern PAP2.

More particularly, the preliminary dopant layer DEL and the first active pattern PAP1 may be etched using the hard mask patterns MP and the first and second sacrificial spacers PSP1 and PSP2 as etch masks, thereby forming the third recesses ARS1. The etching process may be an anisotropic etching process. The third recess ARS1 may be formed between the pair of first sacrificial spacers PSP1. The fourth recesses ARS2 in the preliminary dopant layer DEL and the second active pattern PAP2 may be formed by the same method as the third recesses ARS1.

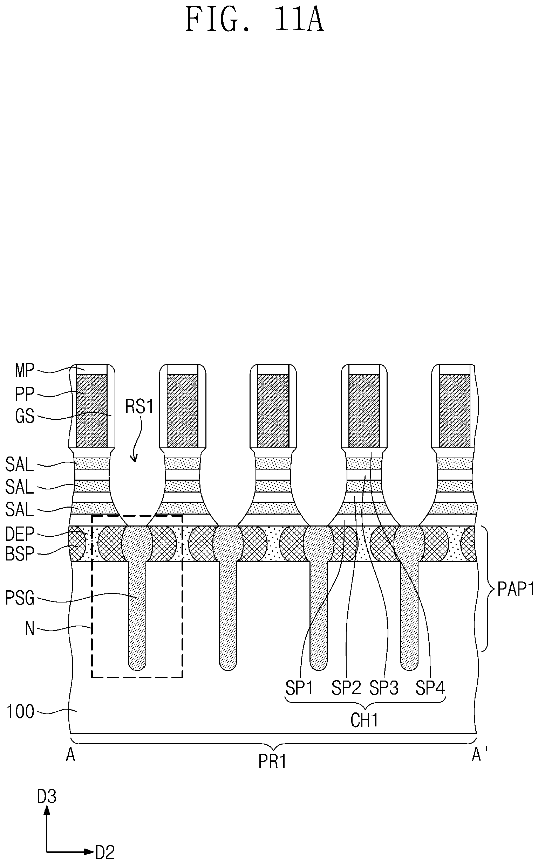

Referring to FIGS. 11A to 11D, a sacrificial plug layer PSG may be formed in each of the third recesses ARS1. The sacrificial plug layer PSG may also be formed in each of the fourth recesses ARS2. The sacrificial plug layers PSG may be formed in the first active pattern PAP1 and the second active pattern PAP2. In other words, the sacrificial plug layer PSG may fill each of the third recesses ARS1 and the fourth recesses ARS2.

Buried spacers BSP may be formed on both side surfaces of the sacrificial plug layer PSG. The buried spacers BSP may be spaced apart from each other in the second direction D2 with the sacrificial plug layer PSG interposed therebetween. The buried spacers BSP may have symmetrical shapes in the second direction D2. The buried spacers BSP may be formed below the first (i.e., lowermost) semiconductor pattern SP1.

A portion of the preliminary dopant layer DEL may remain after the formation of the sacrificial plug layer PSG and the buried spacer BSP. The remaining preliminary dopant layer (DEL of FIG. 10A) may be a dopant layer DEP. The dopant layer DEP may be disposed between the buried spacers BSP.

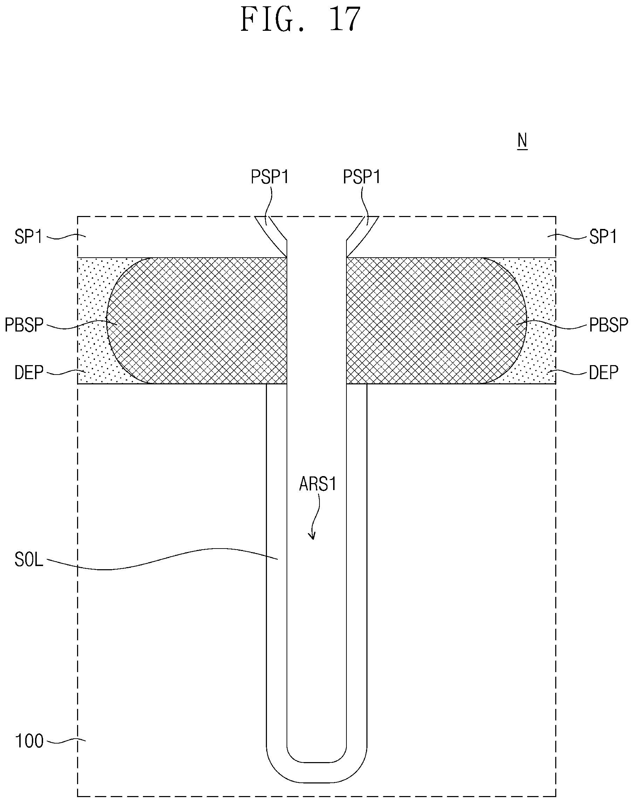

FIGS. 17 to 20 are enlarged views illustrating a method of forming a region 'N' of FIG. 11A. Referring to FIG. 17, a deposition process may be performed in the third recess ARS1 described above, thereby forming a preliminary buried spacer PBSP and a preliminary layer SOL. For example, the deposition process may be a chemical vapor deposition (CVD) process, a physical vapor deposition (PVD) process or an atomic layer deposition (ALD) process, although embodiments are not limited thereto.

The deposition process may be an oxidation process. For example, in the case in which the preliminary dopant layer DEL includes silicon doped with fluorine (F), argon (Ar), oxygen (O) or any combination thereof, the preliminary buried spacer PBSP may include SiOₓ or SiOF. The preliminary layer SOL may include SiOₓ.

In certain embodiments, the deposition process may be a nitridation process. In the case in which the preliminary dopant layer DEL includes silicon doped with nitrogen (N), the preliminary buried spacer PBSP may include SiN_{y}, SiON, SiOCN, or SiCN. The preliminary layer SOL may include SiN_{y}.

More particularly, the preliminary layer SOL may be formed in the third recess ARS1 adjacent to the semiconductor substrate 100. The preliminary buried spacer PBSP may be formed in the third recess ARS1 adjacent to the preliminary dopant layer DEL. Since a concentration of the dopant in the preliminary dopant layer DEL is greater than a concentration of the dopant in the semiconductor substrate 100, a cross-sectional thickness of a layer deposited by the deposition process may be varied according to a region. In other words, a width of the preliminary buried spacer PBSP in the second direction D2 may be greater than a width of the preliminary layer SOL in the second direction D2.

A formation (e.g., deposition) rate of the preliminary buried spacer PBSP by the deposition process may be higher in an empty portion of the third recess ARS1 than in a portion adjacent to the semiconductor substrate 100 and the first semiconductor pattern SP1. In other words, since the formation rate of the preliminary buried spacer PBSP at an interface of the third recess ARS1 is relatively low, a surface of the preliminary buried spacer PBSP facing the dopant layer DEP may be convex; that is, a side surface of the preliminary buried spacer PBSP may be a curved surface.

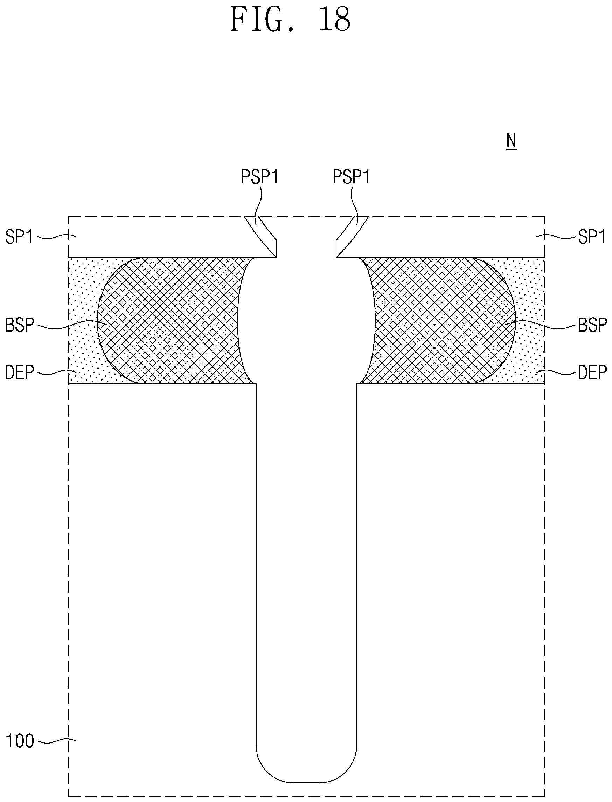

Referring to FIG. 18, an etching process may be performed on the preliminary buried spacer PBSP and the preliminary layer SOL (see FIG. 17) to form the buried spacers BSP. The etching process may be performed using the first sacrificial spacers PSP1 as etch masks. The etching process may be a wet etching process or a dry etching process. For some examples, in the case in which the preliminary buried spacer PBSP includes SiOₓ or SiOF, an etchant of the etching process may include a HF gas. For certain examples, in the case in which the preliminary buried spacer PBSP includes SiN_{y}, SiON, SiOCN or SiCN, the etchant of the etching process may include a phosphoric acid (H₃PO₄) solution. During the etching process, the preliminary layer SOL may be completely removed, and only a portion of the preliminary buried spacer PBSP may be removed.

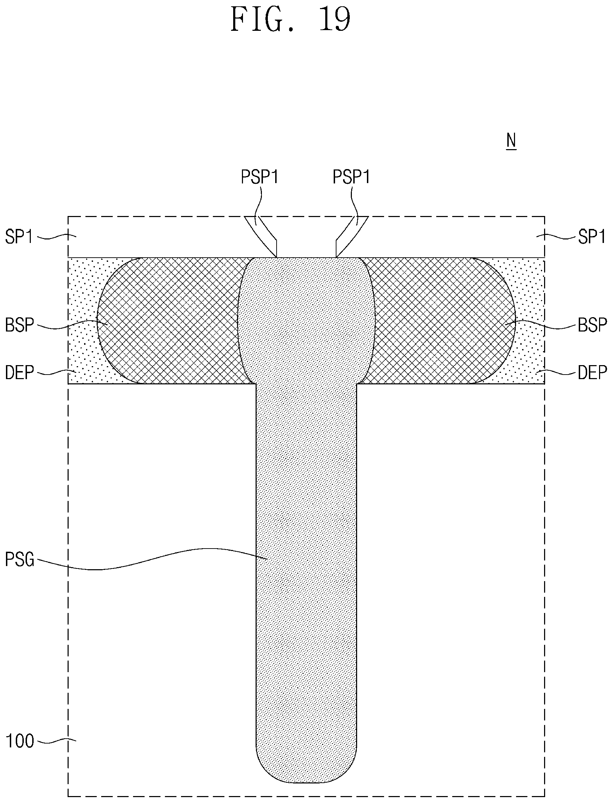

Referring to FIG. 19, after the formation of the buried spacers BSP, the sacrificial plug layer PSG may be formed in the third recess ARS 1. The formation of the sacrificial plug layer PSG may include performing a selective epitaxial growth (SEG) process using the semiconductor substrate 100 as a seed. The sacrificial plug layer PSG may include silicon, germanium, or silicon-germanium, although embodiments are not limited thereto. In particular, the sacrificial plug layer PSG may include silicon-germanium.

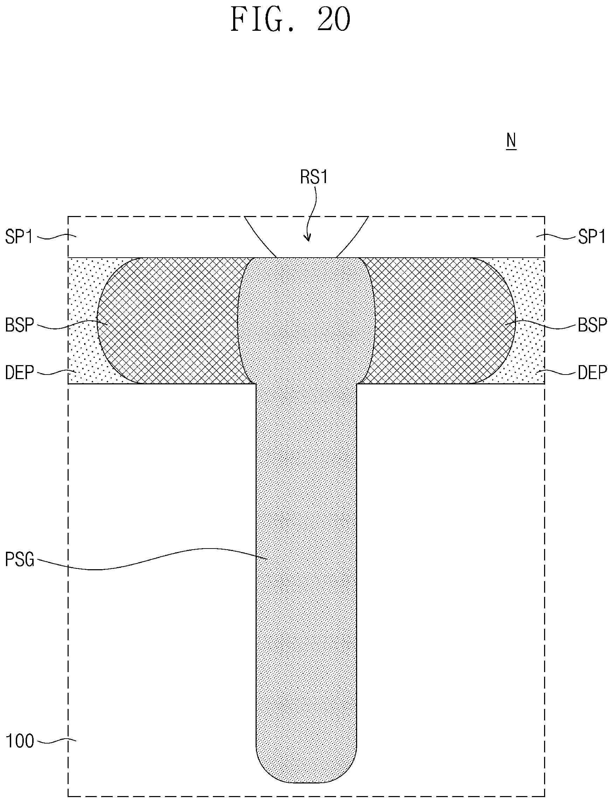

Referring to FIG. 20, the first sacrificial spacers PSP1 may be removed after the formation of the sacrificial plug layer PSG. The first sacrificial spacers PSP1 may be removed by performing an etching process. The etching process may be a wet etching process or a dry etching process. An etchant of the etching process may include a material of selectively etching the first sacrificial spacers PSP1 with respect to the sacrificial plug layer PSG. In other words, the etching process may be performed to remove the first sacrificial spacers PSP1 while leaving the sacrificial plug layer PSG. The second sacrificial spacers PSP2 may be removed by the same method as the first sacrificial spacers PSP1.

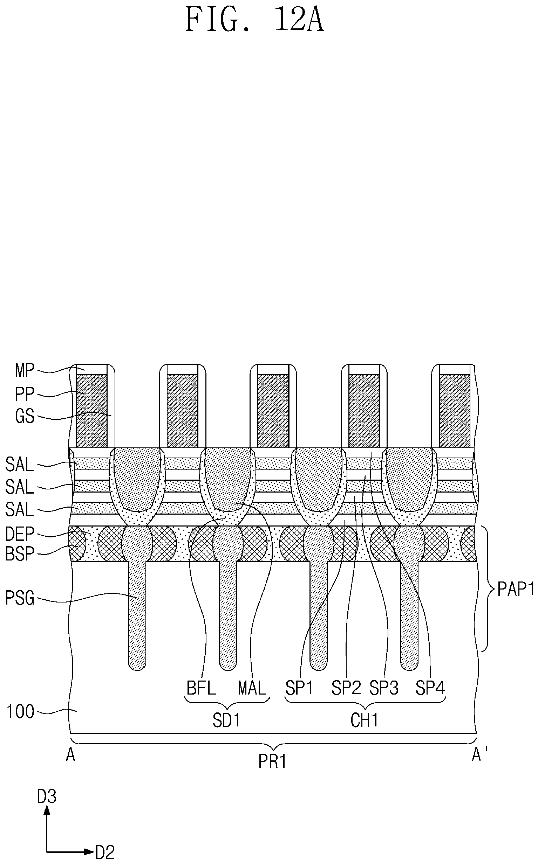

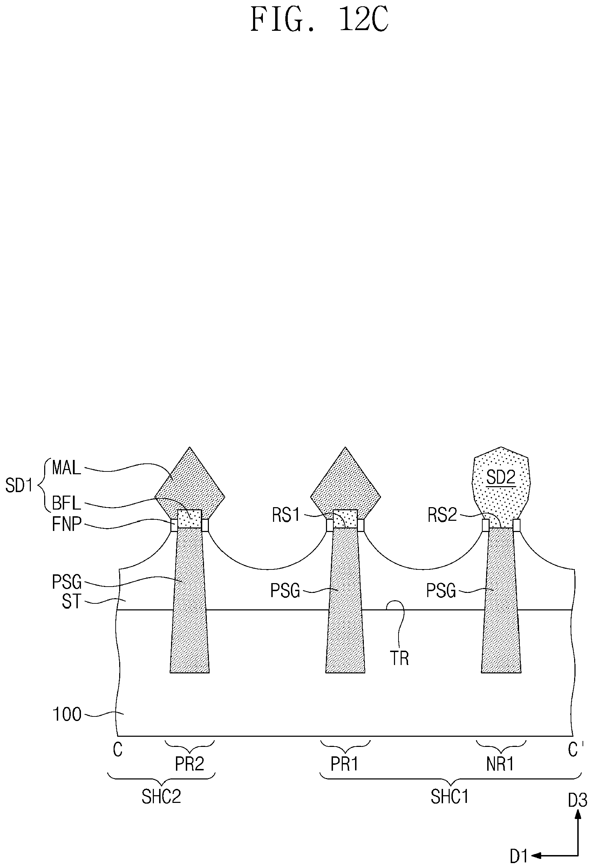

Referring to FIGS. 12A to 12C, first source/drain patterns SD1 may be formed in the first recesses RS1, respectively. The first source/drain pattern SD1 may be formed on the sacrificial plug layer PSG. For example, a first selective epitaxial growth (SEG) process may be performed using an inner surface of the first recess RS1 as a seed layer to form a buffer layer BFL. The buffer layer BFL may be grown using the first to fourth semiconductor patterns SP1, SP2, SP3 and SP4 and the sacrificial plug layer PSG, exposed by the first recess RS1, as a seed. For example, the first SEG process may include a chemical vapor deposition (CVD) process or a molecular beam epitaxy (MBE) process.

The buffer layer BFL may include a semiconductor material (e.g., an element or compound, such as SiGe) of which a lattice constant is greater than a lattice constant of a semiconductor material of the semiconductor substrate 100. The buffer layer BFL may contain a relatively low concentration of germanium (Ge). In certain embodiments of the inventive concepts, the buffer layer BFL may contain silicon (Si) without germanium (Ge). A concentration of germanium (Ge) of the buffer layer BFL may range from about 0 at% to 30 at%.

A second SEG process may be performed on the buffer layer BFL to form a main layer MAL. The main layer MAL may be formed to completely or almost fill the first recess RS 1. The main layer MAL may contain a relatively high concentration of germanium (Ge). For example, a concentration of germanium (Ge) of the main layer MAL may range from about 30 at% to 70 at%.

In some embodiments of the inventive concepts, a third SEG process may be performed on the main layer MAL to form a capping layer. The capping layer may include, for example, silicon (Si). A concentration of silicon (Si) of the capping layer may range from about 98 at% to 100 at%.

Dopants (e.g., boron, gallium or indium) for allowing the first source/drain pattern SD1 to have a p-type conductivity may be injected (e.g., implanted) in-situ during the formation of the buffer layer BFL and the main layer MAL. Alternatively, after the formation of the first source/drain pattern SD1, the dopants may be injected or implanted into the first source/drain pattern SD1.

Second source/drain patterns SD2 may be formed in the second recesses RS2, respectively. The second source/drain patterns SD2 may be formed on the sacrificial plug layer PSG. For example, the second source/drain patterns SD2 may be formed by performing a SEG process using an inner surface of the second recesses RS2 as a seed layer. For example, the second source/drain patterns SD2 may include the same semiconductor material (e.g., Si) as the semiconductor substrate 100.

Dopants (e.g., phosphorus, arsenic or antimony) for allowing the second source/drain pattern SD2 to have an n-type conductivity may be injected (e.g., implanted) in-situ during the formation of the second source/drain patterns SD2. Alternatively, after the formation of the second source/drain patterns SD2, the dopants may be injected or implanted into the second source/drain patterns SD2.

In some embodiments of the inventive concepts, before the formation of the second source/drain patterns SD2, portions of the second semiconductor layers SAL exposed by the second recesses RS2 may be replaced with an insulating material to form inner spacers IP. As a result, the inner spacers IP may be formed between the second source/drain patterns SD2 and the second semiconductor layers SAL, respectively.

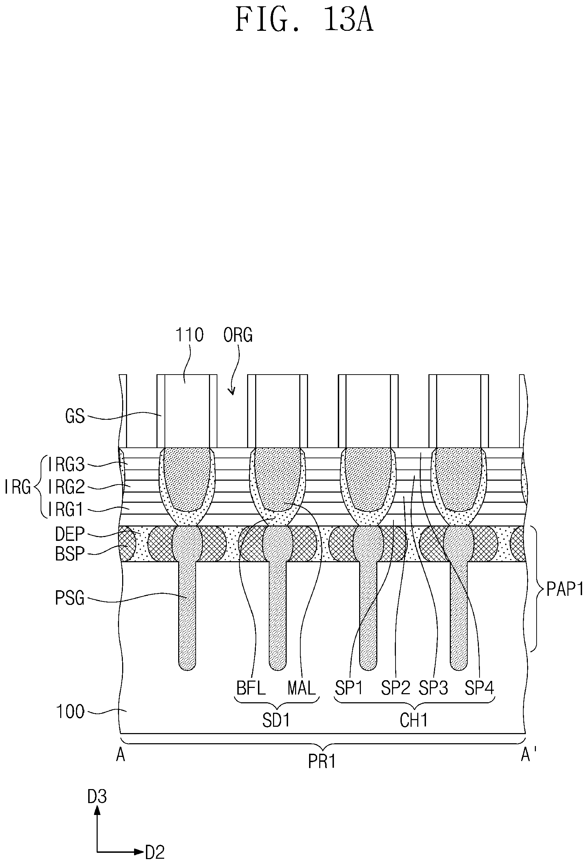

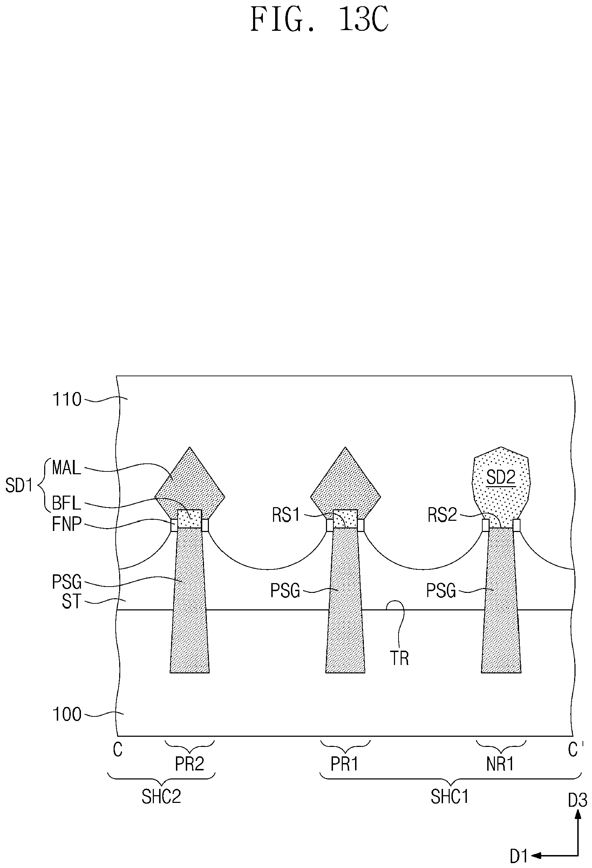

Referring to FIGS. 13A to 13D, a first interlayer insulating layer 110 may be formed to cover the first and second source/drain patterns SD1 and SD2, the hard mask patterns MP and the gate spacers GS. For example, the first interlayer insulating layer 110 may include a silicon oxide layer.

The first interlayer insulating layer 110 may be planarized to expose top surfaces of the sacrificial patterns PP. The planarization of the first interlayer insulating layer 110 may be performed, for example, using an etch-back process or a chemical mechanical polishing (CMP) process. The hard mask patterns MP may be completely removed during the planarization process. As a result, a top surface of the first interlayer insulating layer 110 may be substantially coplanar, in the third direction D3, with the top surfaces of the sacrificial patterns PP and top surfaces of the gate spacers GS.

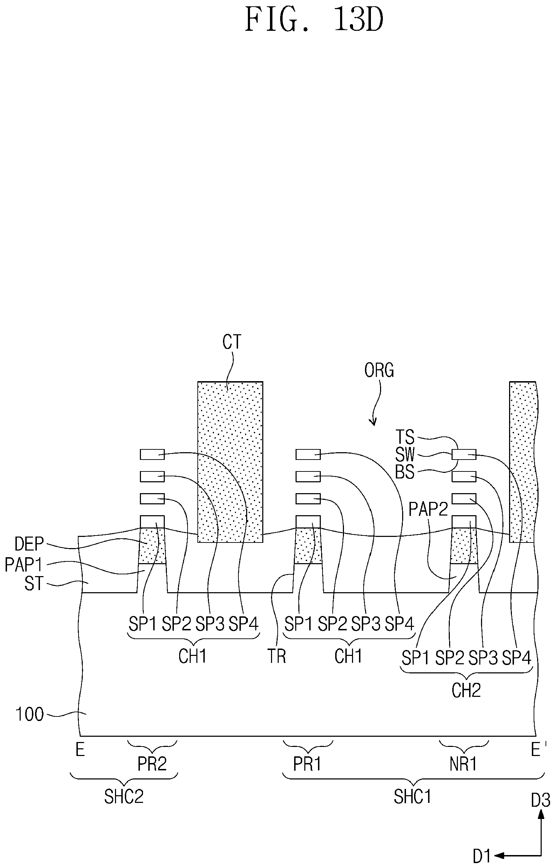

A region of the sacrificial patterns PP may be selectively opened using a photolithography process. For example, regions of the sacrificial patterns PP on the third and fourth boundaries BD3 and BD4 of the first single height cell SHC1 may be selectively opened. The opened region of the sacrificial patterns PP may be selectively etched and thus may be removed. A space formed by the removal of the sacrificial patterns PP may be filled with an insulating material to form a gate cutting pattern CT (see FIG. 13D).

Remaining exposed portions of the sacrificial patterns PP may be selectively removed. An outer region ORG exposing the first and second channel patterns CH1 and CH2 may be formed by the removal of the sacrificial patterns PP (see FIG. 13D). The removal of the sacrificial patterns PP may include performing a wet etching process using an etching solution capable of selectively etching poly-silicon.

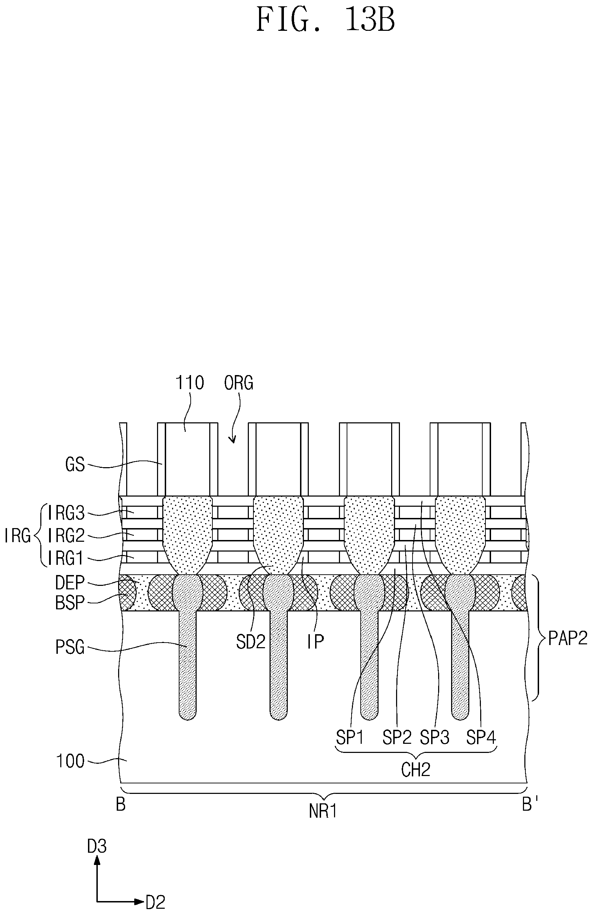

The second semiconductor layers SAL exposed through the outer region ORG may be selectively removed to form inner regions IRG (see FIGS. 13A and 13B). For example, an etching process of selectively etching the second semiconductor layers SAL may be performed to remove the second semiconductor layers SAL while leaving the first to fourth semiconductor patterns SP1, SP2, SP3 and SP4. The etching process may have a high etch rate with respect to silicon-germanium having a relatively high germanium concentration. For example, the etching process may have a high etch rate with respect to silicon-germanium having a germanium concentration greater than 10 at%.

The second semiconductor layers SAL on the first and second PMOSFET regions PR1 and PR2 and the first and second NMOSFET regions NR1 and NR2 may be completely removed during the etching process. The etching process may be a wet etching process. An etching material used in the etching process may quickly remove the second semiconductor layer SAL having a relatively high germanium concentration. Meanwhile, the first source/drain patterns SD1 on the first and second PMOSFET regions PR1 and PR2 may be protected by the buffer layer BFL having a relatively low germanium concentration during the etching process.

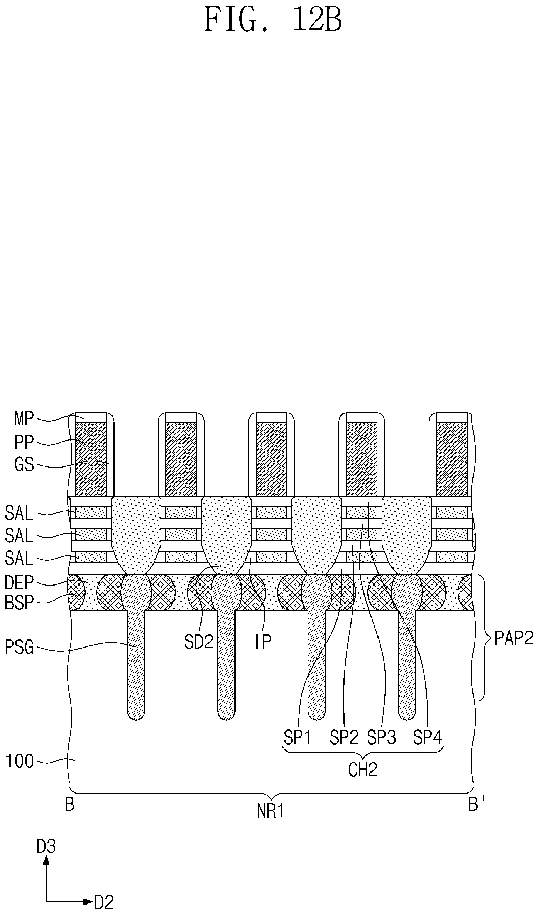

Referring again to FIGS. 13A and 13B, since the second semiconductor layers SAL (see FIG. 12B) are selectively removed, the first to fourth semiconductor patterns SP1, SP2, SP3 and SP4 stacked sequentially in the third direction D3 may remain on each of the first and second active patterns PAP1 and PAP2. First to third inner regions IRG1, IRG2 and IRG3 may be formed by the removal of the second semiconductor layers SAL (see FIG. 12B). More particularly, the first inner region IRG1 may be formed between the first semiconductor pattern SP1 and the second semiconductor pattern SP2, the second inner region IRG2 may be formed between the second semiconductor pattern SP2 and the third semiconductor pattern SP3, and the third inner region IRG3 may be formed between the third semiconductor pattern SP3 and the fourth semiconductor pattern SP4.

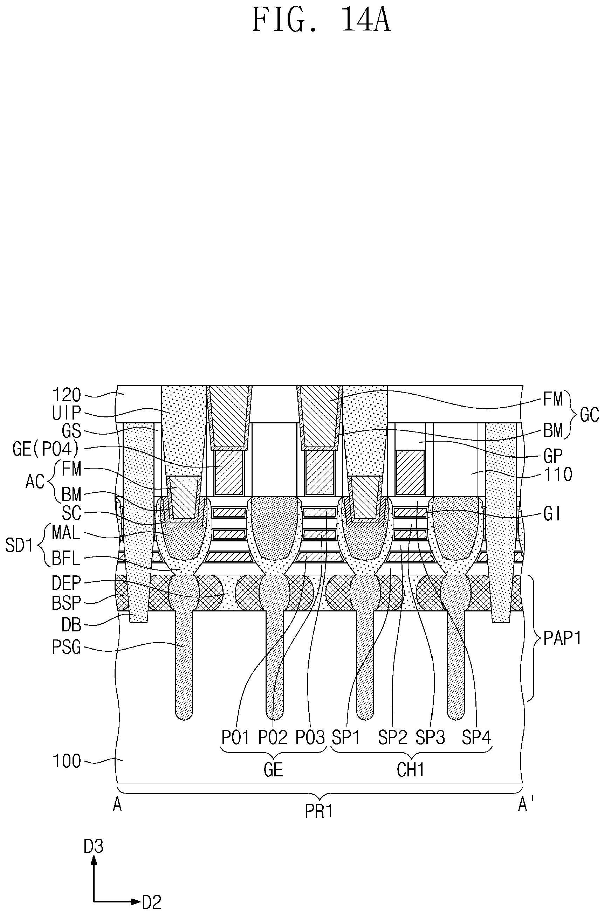

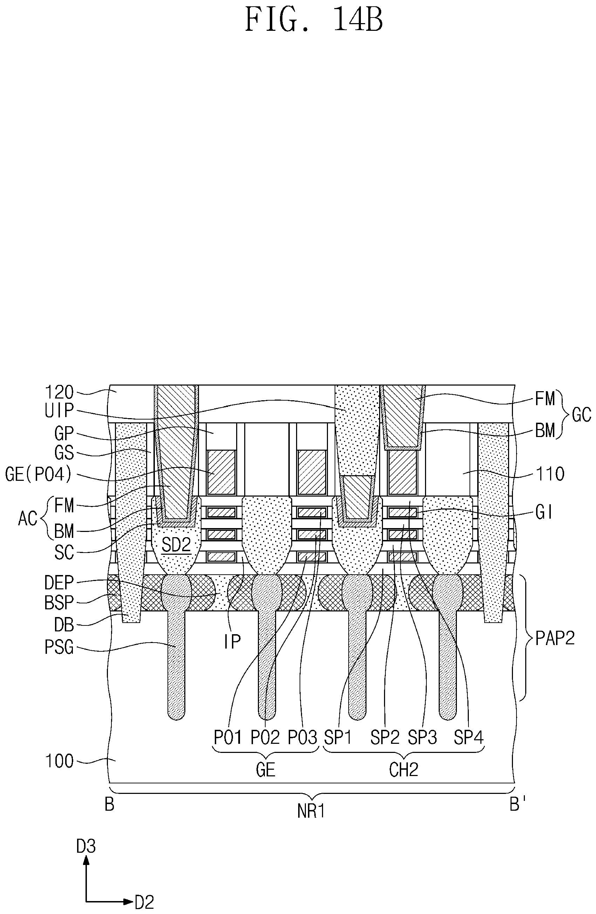

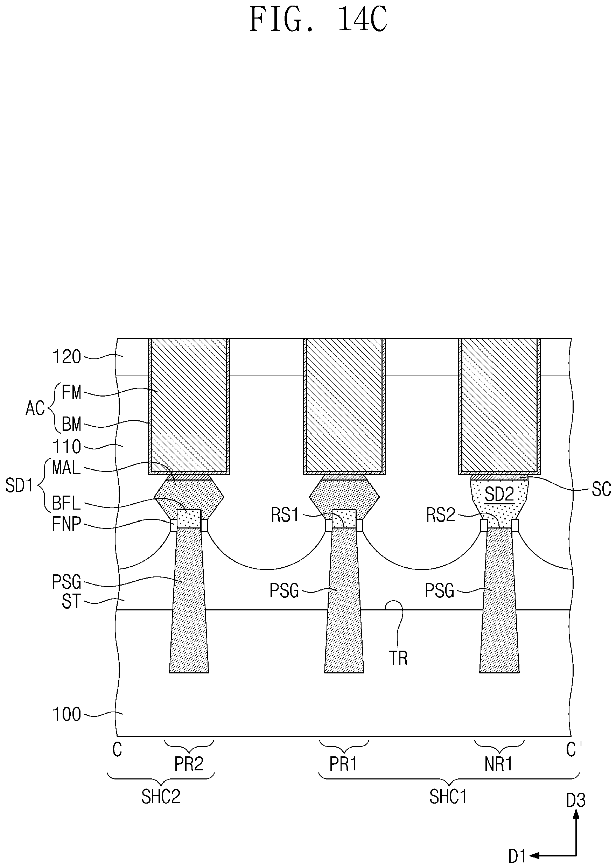

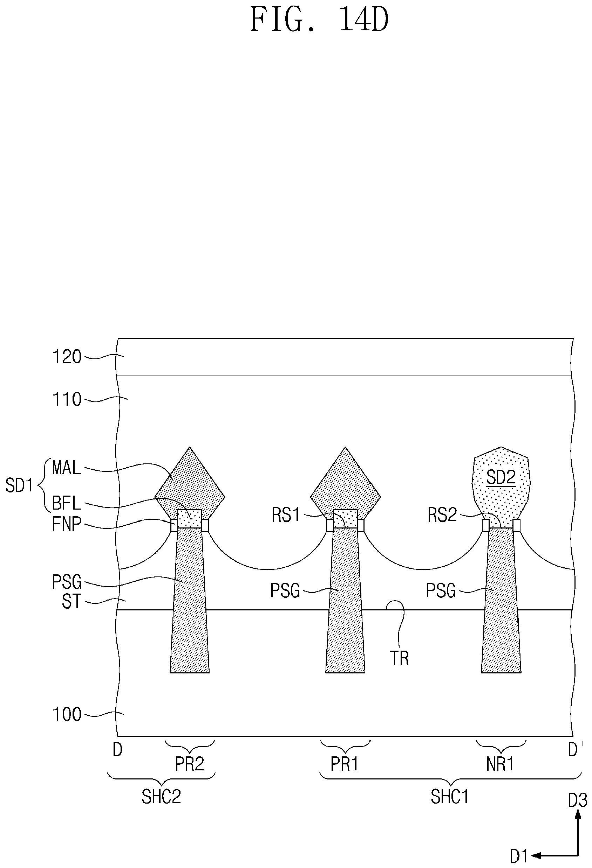

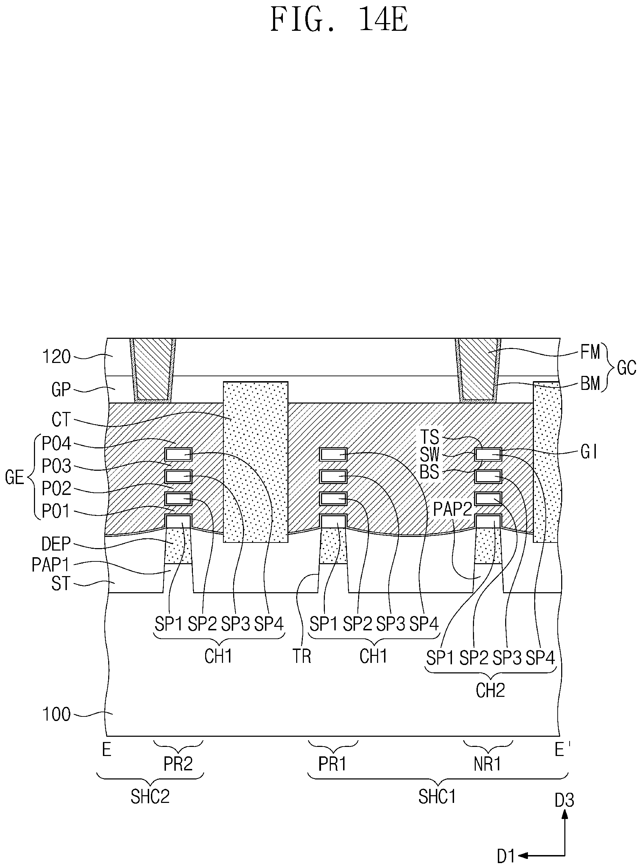

Referring to FIGS. 14A to 14E, a gate insulating layer GI may be conformally formed on the exposed first to fourth semiconductor patterns SP1, SP2, SP3 and SP4. A gate electrode GE may be formed on the gate insulating layer GI. The gate electrode GE may include first to third inner electrodes PO1, PO2 and PO3 formed in the first to third inner regions IRG1, IRG2 and IRG3 (see FIGS. 13A and 13B), respectively, and an outer electrode PO4 formed in the outer region ORG.

The gate electrode GE may be recessed to reduce its height in the third direction D3. Upper portions of the gate cutting patterns CT may also be slightly recessed during the recessing of the gate electrode GE. A gate capping pattern GP may be formed on the recessed gate electrode GE.

A second interlayer insulating layer 120 may be formed on the first interlayer insulating layer 110. The second interlayer insulating layer 120 may include a silicon oxide layer. Active contacts AC may be formed to penetrate (i.e., extend into) the second interlayer insulating layer 120 and the first interlayer insulating layer 110, and the active contacts AC may be electrically connected to the first and second source/drain patterns SD1 and SD2. A gate contact GC may be formed to penetrate the second interlayer insulating layer 120 and the gate capping pattern GP, and the gate contact GC may be electrically connected to the gate electrode GE.

The formation of each of the active contact AC and the gate contact GC may include forming a barrier pattern BM and forming a conductive pattern FM on the barrier pattern BM. The barrier pattern BM may be conformally formed (e.g., covering the conductive pattern FM of the corresponding active contact AC and gate contact GC) and may include a metal layer/a metal nitride layer. The conductive pattern FM may include a low-resistance metal.

Referring again to FIGS. 4 and 5A to 5E, a third interlayer insulating layer 130 may be formed on the active contacts AC and the gate contacts GC. A first metal layer M1 may be formed in the third interlayer insulating layer 130. The first metal layer M1 may include a first interconnection line M1_I electrically connected to at least one of the active contacts AC and the gate contacts GC. A fourth interlayer insulating layer 140 may be formed on the third interlayer insulating layer 130. A second metal layer M2 may be formed in the fourth interlayer insulating layer 140.

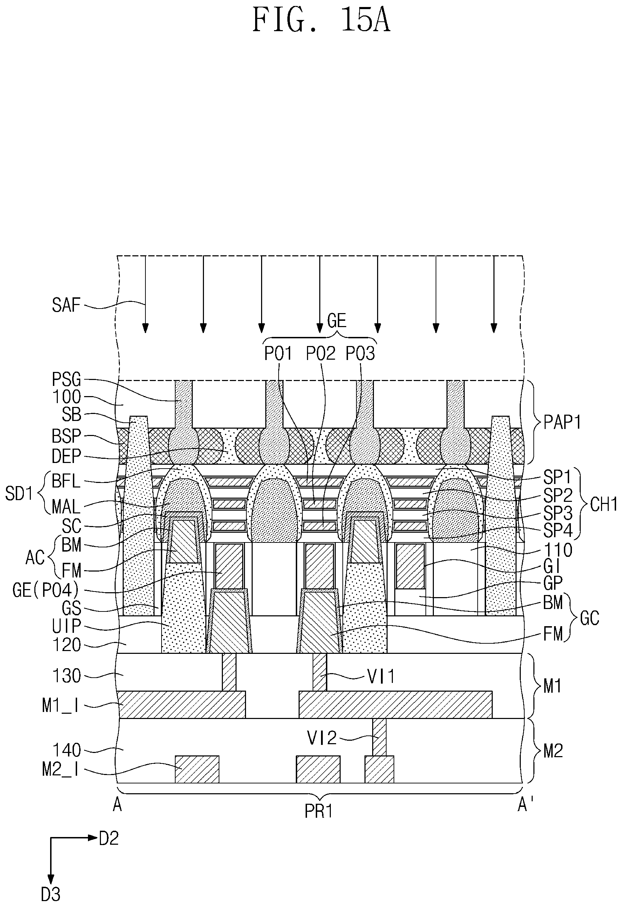

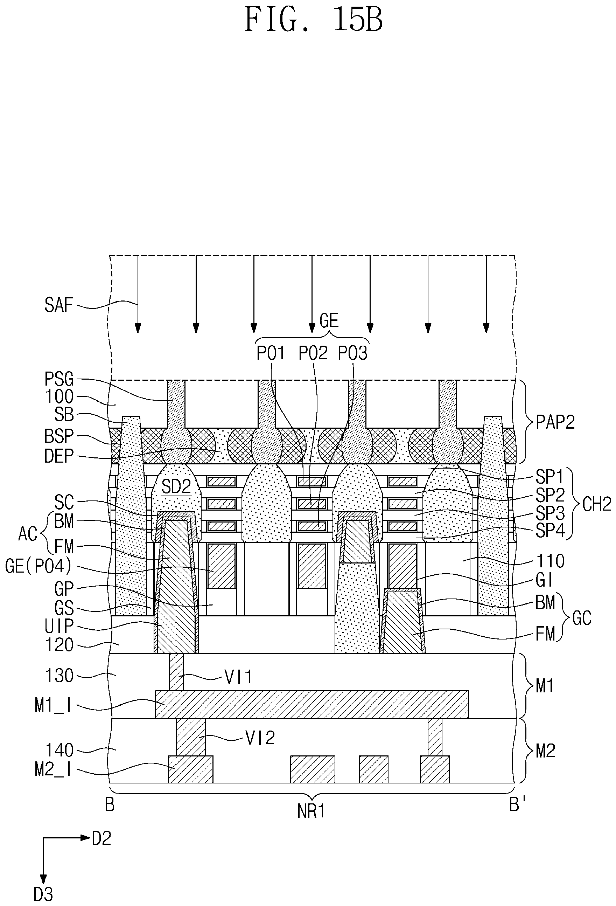

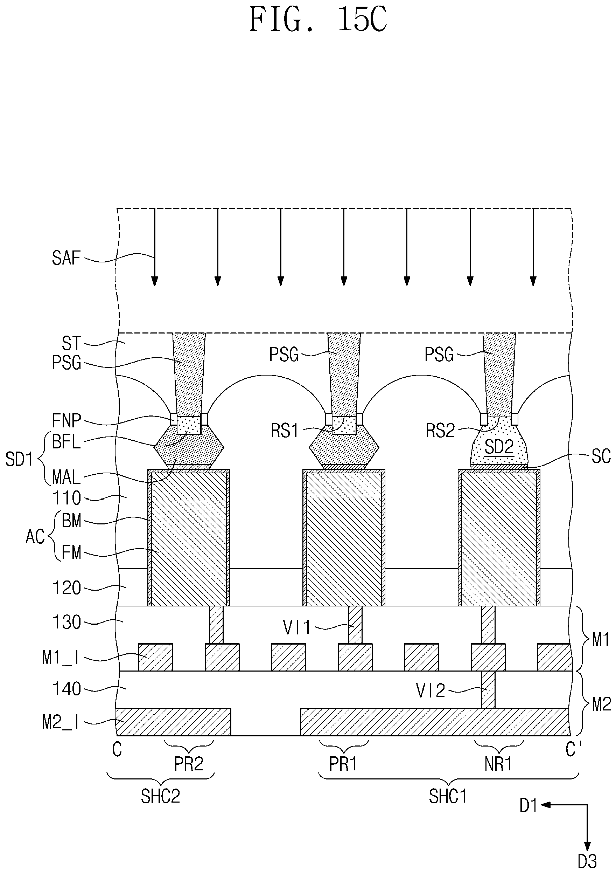

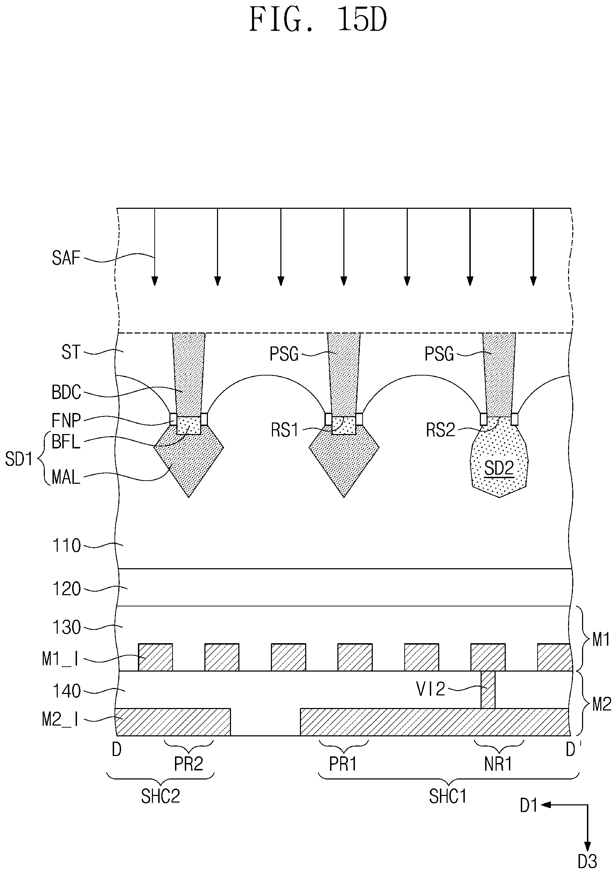

Referring to FIGS. 15A to 15D, after a back-end-of-line (BEOL) process is completed, the semiconductor substrate 100 may be turned over (i.e., flipped vertically) to expose a bottom surface of the semiconductor substrate 100. The exposed bottom surface of the semiconductor substrate 100 may be etched to expose the sacrificial plug layer PSG. In other words, a portion of the semiconductor substrate 100 may be removed.

In some embodiments of the inventive concepts, the removal of the portion of the semiconductor substrate 100 may include performing a planarization process SAF on the bottom surface of the semiconductor substrate 100 to reduce a thickness of the semiconductor substrate 100 in the third direction D3, and performing a cleaning process of selectively removing silicon (Si) on the semiconductor substrate 100. The cleaning process may be performed until the sacrificial plug layer PSG and the device isolation layer ST are exposed. After the cleaning process is performed, an exposed bottom surface of the sacrificial plug layer PSG may be substantially coplanar with an exposed bottom surface of the device isolation layer ST in the third direction D3.

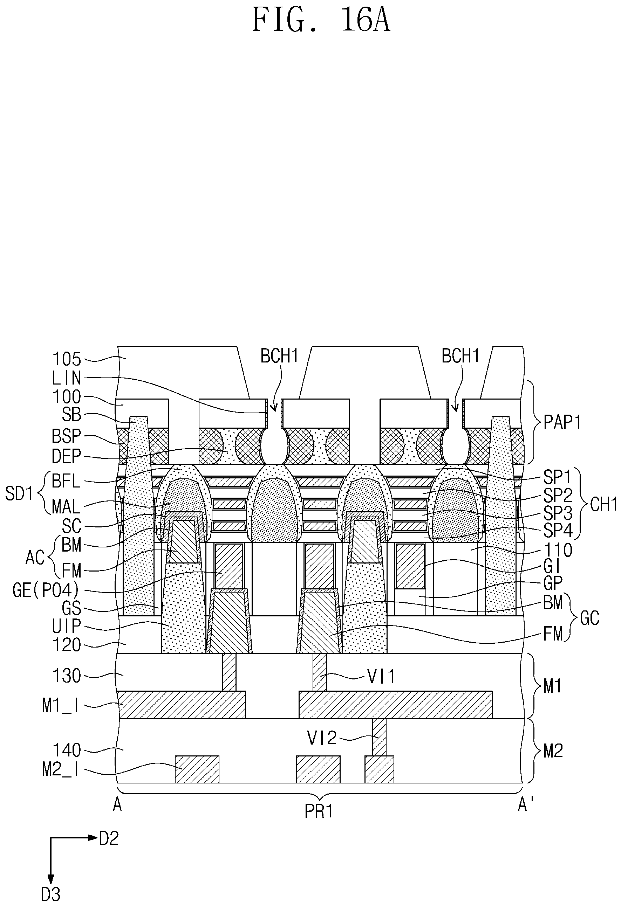

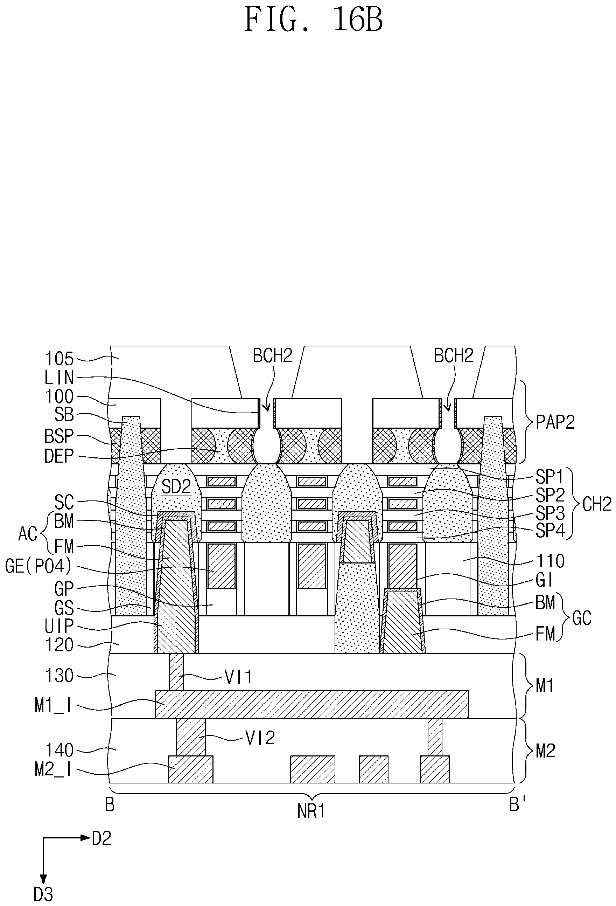

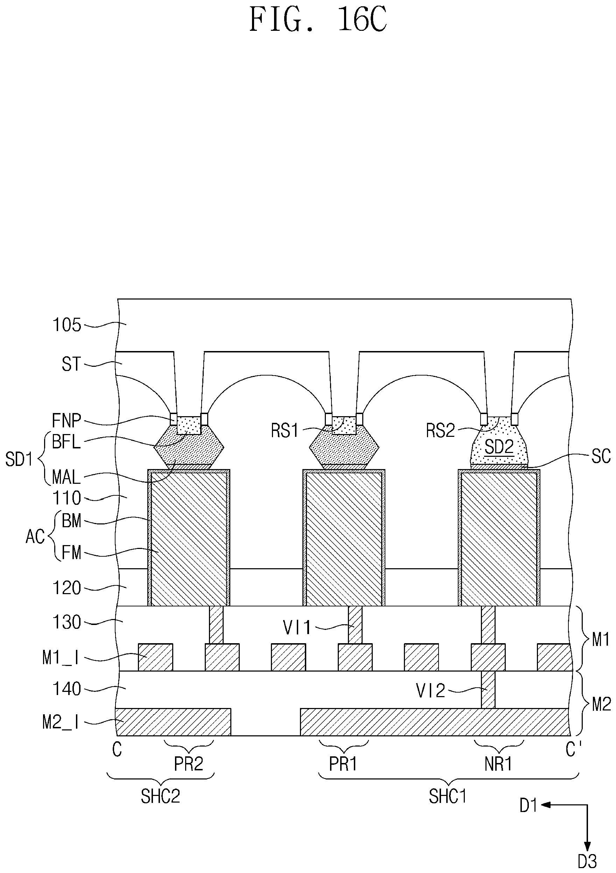

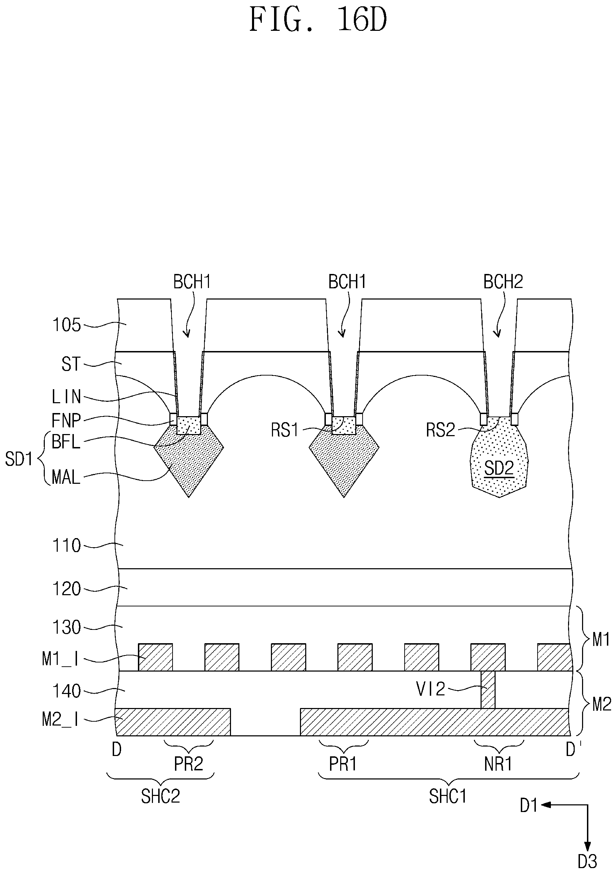

Referring to FIGS. 16A to 16D, the exposed sacrificial plug layer PSG may be removed by performing an etching process. The sacrificial plug layer PSG may be selectively removed using an etchant and not removing the device isolation layer ST and the remaining semiconductor substrate 100. A region formed by the removal of the sacrificial plug layer PSG and the semiconductor substrate 100 may be filled with an insulating material to form a substrate 105. The substrate 105 may include a silicon-based insulating layer. The substrate 105 may include a first insulating pattern AP1 and a second insulating pattern AP2 (see FIGS. 5A and 5B). A portion filled after the removal of the sacrificial plug layer PSG may be the aforementioned protruding portion PJ of the substrate 105 (FIGS. 5A and 5B). A remaining portion except the protruding portion PJ may be the aforementioned horizontal portion HZ of the substrate 105 (FIGS. 5A and 5B).

A mask pattern may be formed on the substrate 105. The mask pattern may be formed using a photolithography process. An anisotropic etching process may be performed on the substrate 105 by using the mask pattern as an etch mask, thereby forming first and second backside contact holes BCH1 and BCH2. The first backside contact hole BCH1 may expose the first source/drain pattern SD1. The second backside contact hole BCH2 may expose the second source/drain pattern SD2.

A liner pattern LIN may be formed on an inner side surface of each of the first and second backside contact holes BCH1 and BCH2. The liner pattern LIN may have a spacer shape. The liner pattern LIN may be formed of a silicon-based insulating material (e.g., SiO, SiN, SiOC or SiOCN). In particular, the liner pattern LIN may include silicon nitride (SiN).

Referring again to FIGS. 4 and 5A to 5E, a contact plug PCP and a contact portion SEC may be formed by filling each of the first and second backside contact holes BCH1 and BCH2 with a metal. A metal-semiconductor compound layer SC may be formed between the contact portion SEC and each of the source/drain patterns SD1 and SD2. The metal-semiconductor compound layer SC, the contact portion SEC and the contact plug PCP in the first backside contact hole BCH1 may constitute a first backside contact BDC1. The metal-semiconductor compound layer SC, the contact portion SEC and the contact plug PCP in the second backside contact hole BCH2 may constitute a second backside contact BDC2.

Lower power interconnection lines VPR1 to VPR3 may be formed on the substrate 105. Each of the lower power interconnection lines VPR1 to VPR3 may be connected to at least one of the first and second backside contacts BDC1 and BDC2. More particularly, each of the lower power interconnection lines VPR1 to VPR3 may be connected to a corresponding one of the first and second backside contacts BDC1 and BDC2 through the via portion VVI. A power delivery network layer PDN may be formed on the lower power interconnection lines VPR1 to VPR3. The power delivery network layer PDN may be formed to apply a source voltage or a drain voltage to each of the lower power interconnection lines VPR1 to VPR3.

According to the inventive concepts, the buried spacer may be formed between the nanosheet and the semiconductor substrate, and thus the leakage current of the channel pattern may be prevented. In addition, the buried spacer may prevent a short phenomenon generated between the source/drain patterns. As a result, the buried spacer may prevent the leakage current from the transistor to the semiconductor substrate and the short phenomenon, and thus electrical characteristics of the semiconductor device may be improved.

According to the inventive concepts, the buried spacer may prevent a short phenomenon generated between the gate electrode and the backside contact connected to the source/drain pattern. As a result, the semiconductor device of the inventive concepts, to which the lower power interconnection lines are applied, may have improved electrical characteristics.

While the embodiments of the inventive concepts have been particularly shown and described, it will be understood by one of ordinary skill in the art that variations in form and detail may be made therein without departing from the scope of the appended claims.

## Claims

1. A semiconductor device, comprising:
an insulating substrate;
a silicon layer on the insulating substrate;
a dopant layer on the silicon layer;
a buried spacer on a side surface of the dopant layer;
a channel pattern on the dopant layer, the channel pattern comprising a plurality of semiconductor patterns stacked and spaced apart from each other in a first direction perpendicular to an upper surface of the insulating substrate;
a source/drain pattern on the buried spacer, the source/drain pattern connected to the channel pattern;
a gate electrode on the channel pattern, the gate electrode comprising a plurality of inner electrodes between the plurality of semiconductor patterns, respectively;
a lower power interconnection line in a lower portion of the insulating substrate; and
a backside contact extending into the insulating substrate and the silicon layer in the first direction to electrically connect the lower power interconnection line to the source/drain pattern,
wherein a side surface of the backside contact is in contact with the silicon layer and the buried spacer.

2. The semiconductor device of claim 1, wherein the backside contact comprises:
a metal-semiconductor compound layer connected to a lower portion of the source/drain pattern;
a contact portion under the metal-semiconductor compound layer;
a contact plug connected to the lower power interconnection line; and
a liner pattern on side surfaces of the contact portion and the contact plug.

3. The semiconductor device of claim 2, wherein the contact plug is connected to a via portion of the lower power interconnection line.

4. The semiconductor device of claim 3, wherein, in a second direction parallel to the upper surface of the insulating substrate, a width of the contact plug is less than a width of the contact portion.

5. The semiconductor device of claim 4, wherein side surfaces of the contact portion are curved surfaces.

6. The semiconductor device of claim 4 or 5, wherein each of side surfaces of the contact portion facing the buried spacer in the second direction is convex.

7. The semiconductor device of any of claims 4 to 6, wherein the width of the contact portion in the second direction gradually increases and then decreases as a distance from the insulating substrate in the first direction increases.

8. The semiconductor device of any of claims 3 to 7, wherein the via portion at least partially overlaps with the contact portion and the buried spacer in the first direction.

9. The semiconductor device of any of claims 3 to 8, wherein a width of the via portion in a second direction parallel to the upper surface of the insulating substrate becomes progressively greater as the via portion extends in the first direction toward the lower power interconnection line.

10. A semiconductor device, comprising:
an insulating substrate including a horizontal portion and a protruding portion;
a silicon layer on the insulating substrate;
a dopant layer on the silicon layer;
a first buried spacer and a second buried spacer on laterally opposite side surfaces of the dopant layer, respectively;
a channel pattern on the dopant layer;
a first source/drain pattern and a second source/drain pattern connected to laterally opposite sides of the channel pattern, respectively;
a gate electrode on the channel pattern;
a lower power interconnection line in a lower portion of the insulating substrate; and
a backside contact extending into the insulating substrate and the silicon layer to electrically connect the lower power interconnection line to the first source/drain pattern,
wherein the protruding portion is in contact with a lower portion of the second source/drain pattern,
wherein the silicon layer is between the protruding portion and the backside contact,
wherein a first side surface of the first buried spacer is in contact with the backside contact, and a second side surface of the second buried spacer is in contact with the protruding portion, and
wherein the first and second buried spacers include an insulating material having a dielectric constant lower than that of silicon oxide.

11. The semiconductor device of claim 10, wherein the insulating material includes silicon oxide (SiOₓ), silicon oxycarbonitride (SiOCN), silicon carbon nitride (SiCN), silicon oxyfluoride (SiOF), or any combination thereof.

12. The semiconductor device of claim 10 or 11, wherein the first buried spacer further comprises a third side surface opposite the first side surface,
wherein the third side surface is in contact with the dopant layer, and
wherein the first and third side surfaces are curved surfaces.

13. The semiconductor device of claim 12, wherein a curvature of the first side surface is less than a curvature of the third side surface.

14. The semiconductor device of any of claims 10 to 13, wherein the second buried spacer further comprises a fourth side surface opposite the second side surface,
wherein the fourth side surface is in contact with the dopant layer,
wherein the second side surface is a planar surface, and
wherein the fourth side surface is a curved surface.

15. The semiconductor device of claim 10 or 11, wherein the first buried spacer further comprises a third side surface opposite the first side surface,
wherein the second buried spacer further comprises a fourth side surface opposite the second side surface,
wherein the third and fourth side surfaces are in contact with the dopant layer,
wherein the first, third and fourth side surfaces are curved surfaces, and
wherein a curvature of the first side surface is less than a curvature of the third side surface and a curvature of the fourth side surface.
